(19) Europäisches Patentamt
European Patent Office
Office européen des brevets

(11) **EP 3 767 457 A1**

(12) **EUROPEAN PATENT APPLICATION**

(43) Date of publication:
**20.01.2021 Bulletin 2021/03**

(51) Int Cl.:
***G06F 7/74*** *(2006.01)*      ***H03M 13/11*** *(2006.01)*

(21) Application number: **19186375.2**

(22) Date of filing: **15.07.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **Nokia Solutions and Networks Oy**
  **02610 Espoo (FI)**
- **Politecnico di Milano**
  **20121 Milano (IT)**

(72) Inventors:
- **RAZZETTI, Luca Gabriele**
  **20871 Vimercate (IT)**
- **GAVIOLI, Giancarlo**
  **20871 Vimercate (IT)**
- **COSTANTINI, Carlo**
  **20871 Vimercate (IT)**
- **CATTANEO, Davide**
  **20871 Vimercate (IT)**
- **BELLINI, Sandro**
  **20900 Monza (IT)**

(74) Representative: **Swindell & Pearson Limited**
**48 Friar Gate**
**Derby DE1 1GY (GB)**

(54) **DATA COMMUNICATION**

(57) An apparatus comprising:
a first register, for a pointer to a current bit position, updated by a clock cycle;
a second register for a current Hamming Weight;
a third register for a current index value; and
adder logic configured to:
determine an interim value based on a coefficient provided from a memory and the current index value,
cause updating of the second and third registers comprising writing an updated index value based on the interim value to the third register.

FIG. 1

EP 3 767 457 A1

**Description**

TECHNOLOGICAL FIELD

Embodiments of the present disclosure relate to data communication. Some relate to data modulation and data de-modulation.

BACKGROUND

Digital modulation is the process of varying one or more properties of a periodic waveform, the carrier signal, with a digital modulating signal that contains information to be transmitted.
The digital modulating signal can be a codeword of modulation symbols.
In quadrature amplitude modulation, the amplitudes of two quadrature carrier signals are varied between multiple values. Each symbol defines an amplitude (level) of the two quadrature carrier signals.

BRIEF SUMMARY

According to various, but not necessarily all, embodiments there is provided an apparatus comprising:

a first register, for a pointer to a current bit position, updated by a clock cycle;
a second register for a current Hamming Weight;
a third register for a current index value; and
adder logic configured to:

determine an interim value based on a coefficient provided from a memory and the current index value,
cause updating of the second and third registers comprising writing an updated index value based on the interim value to the third register.

In some but not necessarily all examples, the adder logic is configured to cause updating of the second register and the third register comprising writing an updated index value based on the coefficient to the third register.
In some but not necessarily all examples, the coefficient is provided from the memory in dependence upon the current index value provided by the third register and the current Hamming Weights provided by the second register.
In some but not necessarily all examples, the apparatus comprises:

means for accessing a set of multiple coefficients stored in the memory using a current value of the current bit position from the first register;
means for selecting one coefficient of the accessed set of multiple coefficients using a current value of the current Hamming Weight from the second register, wherein the selected coefficient is used to determine the interim value.

In some but not necessarily all examples, the coefficient is a truncated coefficient and wherein the adder logic is sized for a mantissa of a truncated coefficient, and is configured to operate on most significant bits of a current index value and a mantissa of the truncated coefficient to produce most significant bits of an interim value, that is added to least significant bits of current index value to obtain the interim value.
In some but not necessarily all examples, the apparatus comprises means for initialization of the first register to a variable value and means for initialization of the second register to a variable value.
In some but not necessarily all examples, the apparatus comprises: in parallel, multiple circuit modules each of which comprises a second register for a current Hamming Weight, a third register for a current index value; and adder logic, wherein the parallel circuits share the first register and/or share the memory.
In some but not necessarily all examples, the apparatus is implemented in hardware comprising application specific circuitry.
In some but not necessarily all examples, the apparatus comprises means for configuring the apparatus for use in a transmitter or for use in a receiver.
In some but not necessarily all examples, the apparatus comprises means for using the current Hamming Weight from the second register and the current index value from the third register as state variables, and the current bit position in the codeword, from the first register, as time-base running sequentially through each bit position in the codeword.
In some but not necessarily all examples, the second register is used to store the Hamming Weight of the remaining symbols in the codeword that are yet to be processed and the third register is used to store the current index value for the remaining symbols in the codeword that are yet to be processed.

In some but not necessarily all examples, the apparatus comprises a look-up table of coefficients values is stored in the memory. In some but not necessarily all examples, the look-up table of coefficient values is based on enumerative coding.

In some but not necessarily all examples, the look-up table of coefficient values is based on constant composition enumerative coding or variable composition enumerative coding. In some but not necessarily all examples, the look-up table is a table of truncated coefficient values.

In some but not necessarily all examples, each clock cycle updates the pointer to a current bit position in the first register, wherein the updated current bit position in the first register selects a row/column in a coefficient table and wherein the Hamming Weight in the second register selects a column/row of the coefficient table.

In some but not necessarily all examples, the apparatus comprises means for transmitting a modulated signal controlled by the codeword.

In some but not necessarily all examples, an optical high speed transmission system comprises, in a transmitter, the apparatus.

In some but not necessarily all examples, the apparatus comprises means for:

converting each data block to an index value; and
enumeratively decoding the index value each clock cycle to obtain with each clock cycle a symbol of the modulation codeword and conditionally, in dependence upon the obtained symbol, obtaining a new index value for enumeratively decoding at the next clock cycle to obtain the next symbol of the modulation codeword.

In some but not necessarily all examples, the interim value is the current index value minus the coefficient provided from the memory.

In some but not necessarily all examples, the apparatus comprises means for using the interim value to determine a condition, wherein when the condition is satisfied the adder logic is configured cause updating of the second and third registers comprising writing the updated index value based on the determined condition to the third register and determining a symbol for the codeword at the current bit position.

In some but not necessarily all examples, the apparatus is configured to:

determine the condition based on a difference between the coefficient and the current index value provided by the third register,
wherein if the difference

i) has a first sense, then a first symbol is found in the codeword at the current bit position, the second register value is decremented by 1 and the third register value is decremented by the coefficient; and
ii) has a second sense, then a second symbol is found in the codeword at the current bit position and there is no change to the second register or the third register. In some but not necessarily all examples, the apparatus comprises means for receiving a modulated signal controlled by the codeword.

In some but not necessarily all examples, an optical high speed transmission system comprises, in a receiver, the apparatus.

In some but not necessarily all examples, the interim value is the current index value added to the coefficient provided from the memory.

In some but not necessarily all examples, the apparatus comprises means for:

enumeratively encoding a symbol of a received codeword each clock cycle to obtain with each clock cycle an updated index value wherein the updated value is conditionally dependent upon the symbol; and
converting a final index value obtained after enumeratively encoding a last symbol of the received codeword to a data block.

In some but not necessarily all examples, the apparatus is configured to:

i) decrement the second register value by 1 and increment the third register value by the coefficient when the codeword at the current bit position has a first symbol; and
ii) not change the second register value and the third register value when the codeword at the current bit position has a second symbol.

According to various, but not necessarily all, embodiments there is provided an equivalent method and/or computer readable instructions.

According to various, but not necessarily all, embodiments there is provided an apparatus comprising means for:

converting each data block to an index value; and
enumeratively decoding the index value each clock cycle to obtain with each clock cycle a symbol of the modulation codeword and conditionally, in dependence upon the obtained symbol, obtaining a new index value for enumeratively decoding at the next clock cycle to obtain the next symbol of the modulation codeword.

According to various, but not necessarily all, embodiments there is provided an apparatus comprising means for:

enumeratively encoding a symbol of a received codeword each clock cycle to obtain with each clock cycle an updated index value wherein the updated value is conditionally dependent upon the symbol; and
converting a final index value obtained after enumeratively encoding a last symbol of the received codeword to a data block.

According to various, but not necessarily all, embodiments, the interim value is the index value or new index value. In a transmitter, the interim value is the current index value minus the coefficient provided from the memory. In a receiver, the interim value is the current index value added to the coefficient provided from the memory.

According to various, but not necessarily all, embodiments there is provided an apparatus comprising:

a first register, for a pointer to a current bit position, updated by a clock cycle;
a second register;
a third register for a current index value; and
adder logic configured to:

determine an interim value based on a coefficient determined by a value of the first register and a value of the second register,
cause updating of the second and third registers comprising writing an updated index value based on the interim value to the third register.

According to various, but not necessarily all, embodiments there is provided an apparatus comprising means for:
converting data blocks that have a first fixed bit length to respective codewords, for controlling transmission, that have a second fixed bit length greater than the first fixed bit length and that have constrained but variable symbol composition comprising:

converting each data block of fixed first bit length to an index value;
enumeratively decoding the index value to obtain a codeword of the second fixed bit length that has a symbol composition that can vary with the index value.

In some but not necessarily all examples, the index value is used in combination with a Hamming Weight to define a unique route through a codeword trellis.

In some but not necessarily all examples, increasing the index value by one maps to a next codeword of the second fixed bit length and Hamming Weight in the range Wmin-Wmax in an ordered set of codewords of the second length and Hamming weight in the range Wmin-Wmax .

In some but not necessarily all examples, each symbol ($S_j$) in the codeword has an associated additive term ($C_{n,w}$) dependent upon an amount of symbols (n) of the codeword remaining to be decoded and upon a total number ($w_j$) of those symbols ($S_j$) remaining in the codeword to be decoded; wherein the index is the sum of the additive terms for the codeword.

In some but not necessarily all examples, the additive terms for enumerative decoding are

$$C_{n,w} = C_{n-1,w} + C_{n-1,w-1}$$

where n is a number of symbols of the codeword remaining to be decoded and w is a Hamming Weight of symbols of the codeword remaining to be decoded;
and wherein the additive terms are generated using a constant composition initialization $C_{n,1}$ = n & $C_{w-1,w}$ = 0 or a variable composition initialization $C_{n,1}$ = n + 1 & $C_{0,w}$ = 1.

In some but not necessarily all examples, the apparatus comprises a memory wherein the additive terms are stored, in the memory, in a look-up table that has a unique value for each different combination of a number of symbols of the codeword remaining to be decoded and a Hamming Weight of symbols of the codeword remaining to be decoded.

In some but not necessarily all examples, the additive terms are truncated to a fixed number of bits of mantissa and variable number of bits of exponent and wherein the mantissa and a value indicative of the exponent are stored in separate look-up tables.

In some but not necessarily all examples, a Hamming Weight of the codeword is a programmable parameter

In some but not necessarily all examples, the codeword of the second fixed bit length has a symbol composition that can vary with the index value up to a maximum value, wherein the maximum value is a programmable parameter.

In some but not necessarily all examples, the first fixed bit length is a programmable parameter and/or wherein the second fixed bit length is a programmable parameter In some but not necessarily all examples, a probability of occurrence of symbols within the codeword is controlled.

In some but not necessarily all examples, control parameters of enumerative decoding are used to control a probability of occurrence of multiple symbols within the codeword. In some but not necessarily all examples, by controlling using one or more of: programming the first length, the second length, the Hamming Weight.

In some but not necessarily all examples, a probability of occurrence
of multiple symbols within the codeword is controlled so that a probability of occurrence of symbols, that result in higher amplitudes when modulated on a carrier, is less than a probability of occurrence of low amplitude symbols.

In some but not necessarily all examples, the apparatus comprises means for:

for each one of multiple contiguous portions of a data block, using a binary matcher to convert each portion of the data block to a binary bit stream to create multiple binary bit streams while controlling a probability of occurrence of logic ones within each of the multiple binary bit streams; and

using the multiple binary bit streams to control a probability of occurrence of multiple multi-level symbols within the codeword so that a probability of occurrence of high amplitude symbols is less than a probability of occurrence of low amplitude symbols. In some but not necessarily all examples, M-1 binary matchers are arranged as a binary tree, where M is the size of a symbol alphabet of the codeword, and wherein a first sub-set and second sub-set of the multiple M-1 binary matchers are configured to generate symbols for the codeword and wherein the second sub-set of the multiple M-1 binary matchers are configured to select the order of the generated symbols in the codeword.

In some but not necessarily all examples, the selector is constant composition. In some but not necessarily all examples, all M-1 binary matchers are in parallel. In some but not necessarily all examples, there are M-1 or log2M binary matchers.

In some but not necessarily all examples, the apparatus comprises means for enumeratively decoding the index value each clock cycle to obtain with each clock cycle a symbol of the codeword and conditionally, in dependence upon the obtained symbol, obtaining a new index value for enumeratively decoding at the next clock cycle to obtain the next symbol of the codeword.

In some but not necessarily all examples, the apparatus comprises means for using a current Hamming Weight and a current index value (I) as state variables, and a current bit position in the codeword (n) as time-base running through each bit position in the codeword.

In some but not necessarily all examples, the apparatus is implemented in hardware comprising application specific circuitry (ASICs).

In some but not necessarily all examples, the apparatus comprises:

a first register, for a pointer to a current bit position, updated each clock cycle;
a second register for a current Hamming Weight;
a third register for a current index value;
adder logic configured to:

determine an interim value based on a coefficient provided from a memory and the current index value,
use the interim value to determine a symbol-dependent condition, wherein when the condition is satisfied the adder logic is configured to
cause updating of the second and third registers comprising writing an updated index value based on the determined condition to the third register and determining a symbol for the codeword at the current bit position.

In some but not necessarily all examples, the interim value is the current index value minus the coefficient provided from the memory, the condition is that the interim value is greater than or equal to zero.

In some but not necessarily all examples, each clock cycle updates the pointer to a current bit position in the first register, wherein the updated current bit position in the first register selects a row in a coefficient table and wherein the Hamming Weight in the second register selects a column of the coefficient table.

In some but not necessarily all examples, the coefficient table is a shared coefficient table.

In some but not necessarily all examples, the apparatus comprises means for: truncation of the additive terms to a fixed number of bits of mantissa and variable number of bits of exponent, and storing the mantissa separately to the exponent, wherein the adder logic is sized for the mantissa, and the adder logic is configured to operate on MSB of current index value and mantissa of the coefficient to produce an MSB interim value, that is added to LSB of current index value to obtain the interim value.

In some but not necessarily all examples, the apparatus comprises means for transmitting a modulated signal controlled by the codeword.

In some but not necessarily all examples, an optical high speed transmission system comprises, in a transmitter, the apparatus.

According to various, but not necessarily all, embodiments there is provided a method comprising: converting data blocks that have a first fixed bit length to respective codewords that have a second fixed bit length greater than the first fixed bit length and that have constrained but variable symbol composition comprising:

> converting each data block of fixed first bit length to an index value;
> enumeratively decoding the index value to obtain a codeword of the second fixed bit length that has a symbol composition that can vary with the index value.

According to various, but not necessarily all, embodiments there is provided computer readable instructions that when implemented using hardware enable: converting data blocks that have a first fixed bit length to respective codewords that have a second fixed bit length greater than the first fixed bit length and that have constrained but variable symbol composition comprising:

> converting each data block of fixed first bit length to an index value;
> enumeratively decoding the index value to obtain a codeword of the second fixed bit length that has a symbol composition that can vary with the index value.

According to various, but not necessarily all, embodiments there is provided an apparatus comprising means for:

> converting codewords that have a second fixed bit length and a constrained but
> variable symbol composition to respective data blocks that have a first fixed bit length less than the second fixed bit length comprising:
> enumeratively encoding the codeword of the second fixed bit length to obtain an index value that varies with a variable symbol composition of the codeword converting each index value to a data block of fixed first bit length.

In some but not necessarily all examples, the index value is used in combination with a Hamming Weight to define a unique route through a codeword trellis.

In some but not necessarily all examples, increasing the index value by one maps to a next codeword of the second fixed bit length and Hamming Weight in the range Wmin-Wmax in an ordered set of codewords of the second length and Hamming weight in the range Wmin-Wmax .

In some but not necessarily all examples, each symbol ($S_j$) in the codeword has an associated additive term ($C_{n,w}$) dependent upon an amount of symbols (n) of the codeword remaining to be decoded and upon a total number ($w_j$) of those symbols ($S_j$) remaining in the codeword to be decoded; wherein the index is the sum of the additive terms for the codeword.

In some but not necessarily all examples, the additive terms for enumerative decoding are

$$C_{n,w} = C_{n-1,w} + C_{n-1,w-1}$$

where n is a number of symbols of the codeword remaining to be decoded and w is a Hamming Weight of symbols of the codeword remaining to be decoded;
and wherein the additive terms are generated using a constant composition initialization $C_{n,1} = n$ & $C_{w-1,w} = 0$ or a variable composition initialization $C_{n,1} = n + 1$ & $C_{0,w} = 1$.

In some but not necessarily all examples, the apparatus comprises a memory wherein the additive terms are stored, in the memory, in a look-up table that has a unique value for each different combination of a number of symbols of the codeword remaining to be decoded and a Hamming Weight of symbols of the codeword remaining to be decoded.

In some but not necessarily all examples, the additive terms are truncated to a fixed number of bits of mantissa and variable number of bits of exponent and wherein the mantissa and a value indicative of the exponent are stored in separate look-up tables.

In some but not necessarily all examples, a Hamming Weight of the codeword is a programmable parameter

In some but not necessarily all examples, the codeword of the second fixed bit length has a symbol composition that can vary with the index value up to a maximum value, wherein the maximum value is a programmable parameter.

In some but not necessarily all examples, the first fixed bit length is a programmable parameter and/or wherein the second fixed bit length is a programmable parameter In some but not necessarily all examples, a probability of occurrence of symbols within the codeword is controlled.

In some but not necessarily all examples, the apparatus comprises means for using a current Hamming Weight and a current index value (I) as state variables, and a current bit position in the codeword (n) as time-base running through each bit position in the codeword.

In some but not necessarily all examples, the apparatus is implemented in hardware comprising application specific circuitry (ASICs).

In some but not necessarily all examples, the apparatus comprises:

a first register, for a pointer to a current bit position, updated each clock cycle;
a second register for a current Hamming Weight;
a third register for a current index value; and
adder logic configured to:

determine an interim value based on a coefficient provided from a memory and the current index value,
cause updating of the second and third registers comprising writing an updated index value based on the interim value to the second register.

In some but not necessarily all examples, each clock cycle updates the pointer to a current bit position in the first register, wherein the updated current bit position in the first register selects a row in a coefficient table and wherein the Hamming Weight in the second register selects a column of the coefficient table.

In some but not necessarily all examples, the coefficient table is a shared coefficient table.

In some but not necessarily all examples, the apparatus comprises means for: truncation of the additive terms to a fixed number of bits of mantissa and variable number of bits of exponent, and storing the mantissa separately to the exponent, wherein the adder logic is sized for the mantissa, and the adder logic is configured to operate on MSB of current index value and mantissa of the coefficient to produce an MSB interim value, that is added to LSB of current index value to obtain the interim value.

In some but not necessarily all examples, the apparatus comprises means for receiving a modulated signal controlled by the codeword.

In some but not necessarily all examples, an optical high speed reception system comprises, in a receiver, the apparatus.

According to various, but not necessarily all, embodiments there is provided a method comprising:
converting codewords that have a second fixed bit length and a constrained but variable symbol composition to respective data blocks that have a first fixed bit length less than the second fixed bit length comprising:
enumeratively encoding the codeword of the second fixed bit length to obtain an index value that varies with a variable symbol composition of the codeword converting each index value to a data block of fixed first bit length.

According to various, but not necessarily all, embodiments there is provided computer readable instructions that when implemented using hardware enable: converting codewords that have a second fixed bit length and a constrained but variable symbol composition to respective data blocks that have a first fixed bit length less than the second fixed bit length comprising:
enumeratively encoding the codeword of the second fixed bit length to obtain an index value that varies with a variable symbol composition of the codeword converting each index value to a data block of fixed first bit length.

According to various, but not necessarily all, embodiments there is provided an apparatus comprising means for:

converting a data block to an index value;
enumeratively decoding the index value to obtain a codeword for controlling transmission; and
controlling the enumerative decoding to control a probability of occurrence of multiple symbols, for modulating transmission, within the codeword.

According to various, but not necessarily all, embodiments there is provided a method comprising:

converting a data block to an index value;
enumeratively decoding the index value to obtain a codeword for controlling transmission; and
controlling the enumerative decoding to control a probability of occurrence of multiple symbols, for modulating transmission, within the codeword.

According to various, but not necessarily all, embodiments there is provided computer readable instructions that when implemented using hardware enable:

converting a data block to an index value;
enumeratively decoding the index value to obtain a codeword for controlling transmission; and
controlling the enumerative decoding to control a probability of occurrence of multiple symbols, for modulating transmission, within the codeword.

According to various, but not necessarily all, embodiments there is provided an apparatus comprising means for:

converting a data block to a codeword, for controlling transmission, that has a symbol composition that can vary; and
controlling a probability of occurrence of multiple symbols, for modulating transmission, within the codeword so that a probability of occurrence of high amplitude symbols is less than a probability of occurrence of low amplitude symbols.

According to various, but not necessarily all, embodiments there is provided an equivalent method and/or computer readable instructions.

According to various, but not necessarily all, embodiments there is provided an apparatus comprising means for:

for each one of multiple contiguous portions of a data block, using a binary matcher to convert each portion of the data block to a binary bit stream to create multiple binary bit streams while controlling a probability of occurrence of logic ones within each of the multiple binary bit streams; and
using the multiple binary bit streams to control a probability of occurrence of multiple multi-level symbols within a codeword, for controlling transmission, so that a probability of occurrence of high amplitude modulation symbols is less than a probability of occurrence of low amplitude modulation symbols.

According to various, but not necessarily all, embodiments there is provided an equivalent method and/or computer readable instructions.

According to various, but not necessarily all, embodiments there is provided an apparatus comprising means for:

converting each data block to an index value; and
enumeratively decoding the index value each clock cycle to obtain with each clock cycle a symbol of the modulation codeword and conditionally, in dependence upon the obtained symbol, obtaining a new index vale for enumeratively decoding at the next clock cycle to obtain the next symbol of the modulation codeword.

According to various, but not necessarily all, embodiments there is provided an equivalent method and/or computer readable instructions.

According to various, but not necessarily all, embodiments there is provided an apparatus comprising means for:

enumeratively encoding a symbol of a received codeword each clock cycle to obtain with each clock cycle an updated index value wherein the updated value is conditionally dependent upon the symbol; and
converting a final index value obtained after enumeratively encoding a last symbol of the received codeword to a data block.

According to various, but not necessarily all, embodiments there is provided an apparatus comprising:

a first register, for a pointer to a current bit position, updated by a clock cycle;
a second register for a current Hamming Weight;
a third register for a current index value; and
adder logic configured to:

determine an interim value based on a coefficient provided from a memory and the current index value,

cause updating of the second and third registers comprising writing an updated index value based on the interim value to the second register.

According to various, but not necessarily all, embodiments, the interim value is the index value or new index value. In a transmitter, the interim value is the current index value minus the coefficient provided from the memory. In a receiver, the interim value is the current index value added to the coefficient provided from the memory. According to various, but not necessarily all, embodiments there is provided an equivalent method and/or computer readable instructions.

According to various, but not necessarily all, embodiments there is provided examples as claimed in the appended claims.

BRIEF DESCRIPTION

Some example embodiments will now be described with reference to the accompanying drawings in which:

FIG. 1 shows an example embodiment of the subject matter described herein;
FIG. 2 shows another example embodiment of the subject matter described herein;
FIG. 3 shows another example embodiment of the subject matter described herein;
FIG. 4A shows another example embodiment of the subject matter described herein;
FIG. 4B shows another example embodiment of the subject matter described herein;
FIG. 5 shows another example embodiment of the subject matter described herein;
FIG. 6 shows another example embodiment of the subject matter described herein;
FIG. 7 shows another example embodiment of the subject matter described herein;
FIG. 8 shows another example embodiment of the subject matter described herein;
FIG. 9 shows another example embodiment of the subject matter described herein;
FIG. 10 shows another example embodiment of the subject matter described herein;
FIG. 11 shows another example embodiment of the subject matter described herein;
FIG. 12 shows another example embodiment of the subject matter described herein;
FIG. 13 shows another example embodiment of the subject matter described herein;
FIG. 14 shows another example embodiment of the subject matter described herein;
FIG. 15 shows another example embodiment of the subject matter described herein;
FIG. 16 shows another example embodiment of the subject matter described herein;
FIG. 17 shows another example embodiment of the subject matter described herein;
FIG. 18 shows another example embodiment of the subject matter described herein;
FIG. 19 shows another example embodiment of the subject matter described herein;
FIG. 20 shows another example embodiment of the subject matter described herein;
FIG. 21 shows another example embodiment of the subject matter described herein.

DEFINITIONS

Distribution matching: A distribution matcher accepts any sequence of bits $b_k$ (of length $N_b$) and produces a block of N symbols $S_k$ (a codeword) drawn from an alphabet of size M with a desired arbitrary probability distribution. A binary distribution matcher has M=2.

Shaping rate: is the input block size to output block size Nb/N

Fixed length distribution matching: Fixed length to fixed length distribution matching: Nb is fixed, N is fixed.

Probabilistic amplitude shaping: Probabilistic selection of symbols from a symbol alphabet such that constellation points with higher amplitude are selected less frequently and in random order than constellation points with lower amplitude. A frequency of selection of symbols is dependent upon a probability-amplitude distribution. The shape of the probability-amplitude distribution causes low-amplitude symbols to be selected more frequently on average than high-amplitude symbols. Hamming Weight: the Hamming weight of a sequence is the number of symbols that are different from the zero-symbol of the alphabet used. For a binary alphabet, it is the number of ones. The Hamming weight for a particular symbol in a sequence is the number of times that particular symbol is used in the sequence.

Constant composition: The Hamming Weight for the codewords is a fixed value. For example, all codewords of length N have W ones. The number of combinations is given by binomial coefficient $\binom{N}{W} = N!/W!(N-W)!$

Variable composition: The Hamming Weight for the codewords is any value up to a fixed value (up to the codeword length). For example, all codewords of length N have k ones with k=0, 1, 2..W, where W≤N The number of combinations is given by $\sum_{k=0}^{W} \binom{N}{k}$. Variable composition has more combination available than constant composition.

Enumerative coding: an indexing algorithm that assigns a unique integer index between 0 and the number of codewords N for uniquely referencing a codeword amongst the N codewords ordered for example in lexicographic or co-lexicographic order.

Multi-level distribution matcher: a distribution matcher that operates at symbolic level, where different combinations of bits represent an amplitude (level) of a symbol

## DETAILED DESCRIPTION

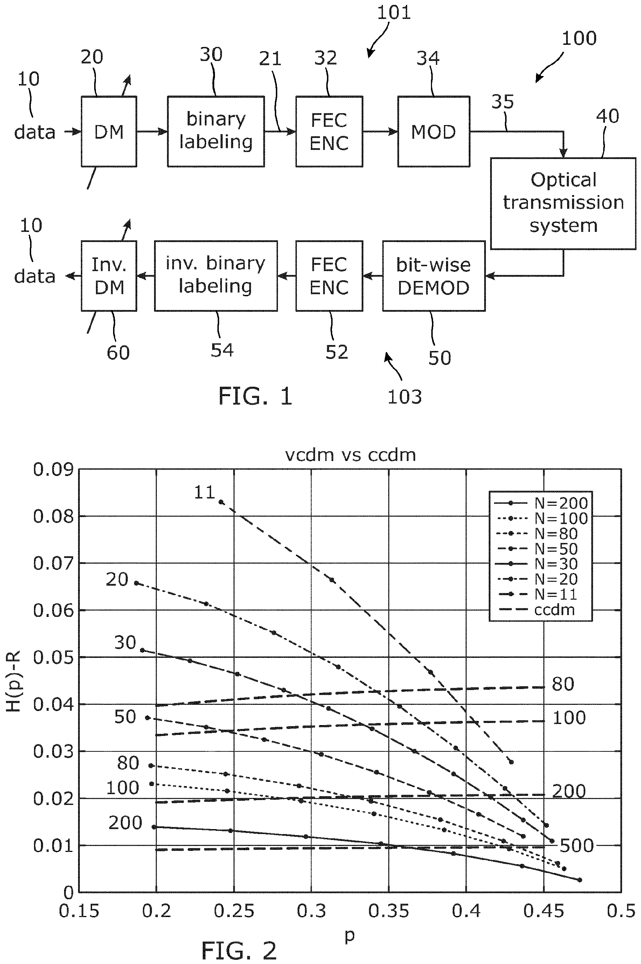

**FIG 1** illustrates an example of a data communication system 100 comprising a transmitter apparatus 101 and a receiver apparatus 103.

In this example, the system 100 is an optical communication system. In some, but not necessarily all, examples, it is a high speed coherent optical communication system. In this context high speed means an information rate of >100 Gb/s or, in some circumstances, >1 Tb/s.

The transmitter 101 is configured to transmit a modulated carrier signal 35 through an optical channel 40 to a receiver 103. A stream of symbols 21 has been modulated onto a carrier signal by a modulator 34 to form the modulated carrier signal 35.

The data 10 comprises information bits. The information bits are used to generate a sequence of symbols 21 (a codeword). The sequence of symbols 21 are channel coded 32 and modulated 34 before being transmitted via the communication channel 40. The transmitted modulated signal 35 is controlled by the codeword and transfers the data 10.

In this example, quadrature amplitude modulation is used to modulate the carrier signal. In quadrature amplitude modulation (QAM), an ordered group of N binary bits ( a symbol) is converted to a unique combination of phase shift and amplitude. This unique combination can be represented as a point (X, Y) in an Argand diagram. A constellation diagram is an Argand diagram that represents the location, that is the constellation point (X, Y) of each modulation symbol. The set of M symbols for a given modulation is a modulation alphabet, where $M=2^N$. A particular alphabet M is used for M-QAM modulation and this defines a constellation of M distinct points each of which represents a symbol. The modulator 34 modulates a stream of symbols of the constellation onto the carrier signal

The transmitted information is demodulated 50 and channel decoded 52 to reproduce the sequence of symbols 21. The sequence of symbols 21 are used to recover the data 10.

In some but not necessarily all examples, the data 10 is processed, for example converted to an index which is enumeratively decoded, to produce the sequence of symbols 21.

In some but not necessarily all examples, a block of data 10 of size Nb is converted to a larger block of symbols 21 (a codeword) of size N by the matcher 20.

In some examples, the block of symbols 21 (the codeword) of size N has a variable composition (a variable Hamming Weight W) that can be controlled. Controlling the Hamming Weight W used by the matcher 20 can be used to control the probability distribution of the symbols.

In some but not necessarily all examples, the symbols can be produced with a controlled probability distribution, through a distribution matcher (DM) 20. For example, in probabilistic amplitude shaping, N-QAM symbols 35 of lower amplitude can be produced with a higher probability than symbols of a higher amplitude.

In the example illustrated, the symbols produced by the distribution matcher (DM) 20 (the amplitudes) are combined with the signs of parity bits generated by the systematic encoder 32, before being modulated by a modulator 34 and transmitted.

In some but not necessarily all examples the communication channel 40 is an optical transmission system, for example, an optical high speed transmission system.

At the receiver end, after decoding 50, 52, a de-matcher 60 transforms the sequence of symbols 21 back into the information bit stream, data 10.

Very high bit rates can be achieved. It at least some examples, the hardware complexity of the matcher 20 is such that it enables implementation using application specific integrated circuit (ASIC) technology. In at least some examples, the hardware complexity of the de-matcher 60 is such that it enables implementation using application specific integrated circuit (ASIC) technology

The distribution matcher 20 is a device that accepts any sequence of bits $b_k$ (of length, say, $N_b$) and produce a block of N symbols, $S_k$ drawn from an alphabet of size M with the desired probability distribution.

The ratio of the input block size $N_b$ over the output block size N is defined as Shaping Rate, and determines the performances / amount of bit redundancy of the distribution matcher. The distribution matcher 20 accepts any block of $N_b$ bits, and produces a block of N symbols, where N> $N_b$. Not all sequences of symbols are used, there is symbol redundancy.

The distribution de-matcher 60 reverses the process performed by the distribution matcher 20. It receives a block of N symbols, $S_k$ drawn from an alphabet of size M, with the desired probability distribution, by the distribution matcher 20 and reproduces the original sequence of bits $b_k$ (of length $N_b$) received by the distribution matcher 20.

There is a one-to-one correspondence between blocks of bits and blocks of symbols. This enables the de-matcher 60 to retrieve a block of bits from a block of symbols.

In this way, fixed length sequences of symbols are associated to fixed-length sequences of bits. The block length $N_b$ is a fixed variable, and buffering is not needed. Also synchronization between blocks of bits and blocks of symbols is maintained because both N and $N_b$ are fixed. The fixed-length to fixed-length distribution matcher 20 does not need a buffer to manage random fluctuations of the number of information bits carried by a block of symbols 21.

The shaping rate is the ratio of the input block size to the output block size (Nb/N). Although this is fixed, it can be varied.

The Hamming weight W of a block of symbols 21 (a codeword) is the number of symbols that are different from the zero-symbol of the alphabet used. For a binary alphabet, it is the number of ones.

Constant composition matching keeps the Hamming Weight W for the codewords produced fixed at a value W.

The matcher 20/de-matcher 60 use a one-to-one mapping between a codeword of N symbols containing respectively $K_1$, $K_2$... $K_M$ of the symbols $S_1$, $S_2$... $S_M$, taken in any order, and a sequence of $N_b$ bits.

In constant composition matching, the values $K_1$, $K_2$... $K_M$ are the same and thus only one value of K exists for all sequences.

$$N_b \leq \left\lfloor \frac{N!}{K_1! \, K_2! \, ... \, K_M!} \right\rfloor < NH(S)$$

and the distribution matcher incurs a rate loss $H(S) - N_b/N$.

For a binary alphabet, all codewords of length N exhibit k=K (ones). The total number of combinations is given by the binomial coefficient (N over K).

$$\binom{N}{K} = \frac{N!}{K! \, (N - K)!}$$

The Hamming Weight W has a fixed value for constant composition matching, it is constrained to a single value. For binary symbols, the constant composition codewords of length N are those codewords which exhibit k (ones), with a single fixed k selected from k = 0:N

Variable composition matching allows the Hamming Weight W for the codewords produced to vary up to a maximum fixed value W.

In at least some examples, a probability distribution of symbols 21 in a codeword can be controlled by controlling the Hamming Weight.

In the example provided above, the composition of the output symbol sequence 21 is variable. The values $K_1$, $K_2$... $K_M$ are variable.

The Hamming Weight W has a maximum value for variable composition. and is constrained to a value from a set of values. For binary symbols, the variable composition codewords of length N are those codewords which exhibit k (ones), with each k = 0:N. Variable composition has more available codewords of length N that constant composition.

The advantage of variable composition matching over constant composition matching can be appreciated from **FIG 2.** FIG 2 plots the information rate loss (H(p)-R) for the case M=2 (binary alphabet) and various desired distributions [1-p p] of output binary symbol probability. The constant composition matching curves are plotted as dashed curves for various lengths N (written just besides each curve to the right), whereas solid curves refer to variable composition matching and the block lengths are shown in the legend and written beside each curve to the left. It can be seen that variable composition matching achieves a smaller rate loss for any fixed block length, or the same rate loss with much smaller block lengths. For "large" values of p, the advantage can be more than one order of magnitude.

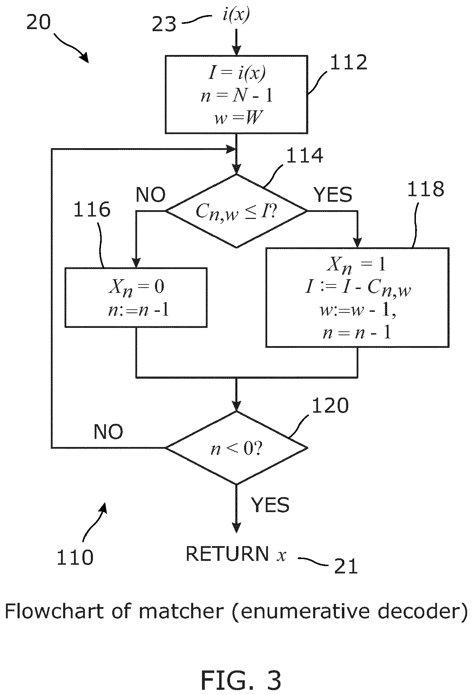

**FIG 3** illustrates a matching algorithm 110 that can be performed by the matcher 20. An index i(x) 23 produced from a block of $N_b$ bits $b_k$ 10 produces a block of N symbols, $S_k$ 21. The integer index uniquely identifies a symbol sequence 21 of hamming weight W. The integer index in combination with the Hamming Weight defines a unique route through a codeword trellis.

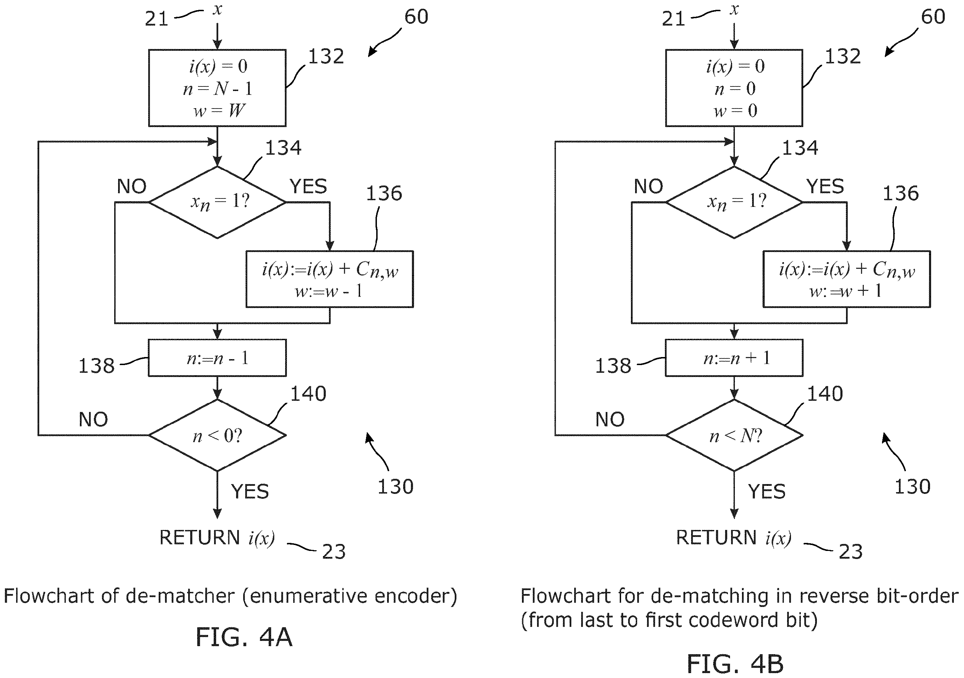

**FIG 4A** illustrates a corresponding de-matching algorithm that can be performed by the de-matcher 60.

A block of N symbols, $S_k$ 21 reproduces the index i(x) 23 which can be converted back to the block of $N_b$ bits $b_k$ 10.

In the example illustrated the matcher 20 operates as an enumerative decoder by converting an index to a block x of symbols 21. The de-matcher 60 operates as an enumerative encoder by converting a block x of symbols 21 to an index.

The block of $N_b$ bits $b_k$ 10 and the block of N symbols, $S_k$ 21 are constrained sequences. The constraints are the fixed lengths Nb, N and the Hamming Weight W. The Hamming Weight W has a fixed value for constant composition matching. The Hamming Weight W has a maximum value for variable composition matching.

For simplicity of explanation, a binary alphabet (M=2) is used in the following example. However, it should be appreciated that other symbols alphabets can be used e.g. M>2.

Enumerative encoding establishes a one-to-one mapping between bit sequences of length $N_b$, and symbol sequences of length N (N> $N_b$) and hamming weight W via integer indices.

There is a one-to-one mapping between bit sequences of length $N_b$, and enumeratively encoded integer indices i(x) 23. For example, bit sequences of length $N_b$ 10 can be converted to an enumeratively encoded integer index i(x) 23 using binary-to-decimal conversion.

There is a one-to-one mapping between enumeratively encoded integer indices i(x) 23 and symbol sequences 21 of length N (N> $N_b$) and hamming weight W. Enumeratively encoding the symbol sequences 21 of length N (N> $N_b$) and hamming weight W will produce the enumeratively encoded integer index i(x) 23.

Each enumeratively encoded integer index i(x) 23 uniquely maps to a particular symbol sequence 21 of length N (N> $N_b$) and hamming weight W.

Increasing the index value by one maps to a next symbol sequence (codeword) of length N (N> $N_b$) and Hamming Weight W in a lexicographically ordered set of codewords of length N and Hamming weight W. The lexicographic ordering sorts codewords as an ordered sequence of symbols based primarily on a position of the symbol and secondarily a value of the symbol. The lexicographic ordering sorts codewords 'alphabetically' (reading left to right) where each symbol in the codeword represents a letter in a word. Lexicographical order can be 'forward' starting at the least significant symbol e.g. 000, 001, 010, 011, 100, 101, 110, 111 or reverse starting at the most significant symbol e.g. 111, 110, 101, 100, 011, 010, 001, 000. Co-lexicographic ordering is also possible. Co-lexicographic ordering sorts codewords 'alphabetically' (but reading right to left) where each symbol in the codeword represents a letter in a word. Lexicographical order can be 'forward' starting (at the right) at the least significant symbol e.g. 000, 100, 010, 110, 001, 101, 011, 111 or reverse starting at the right at the most significant symbol e.g. 111, 011, 101, 001, 110, 010,100, 000.

The indices i(x) 23 are contiguous. Each index corresponds to a symbol sequence 21 (a unique route through a trellis).

To encode $N_b$ information bits, indices range from 0 to $2^{N_b}-1$. The matcher addresses $2^{N_b}$ sequences, the remaining symbol sequences $(2^N - 2^{N_b})$ are not used (symbol redundancy).

Assume S is the set of codewords, for example binary symbol sequences (M=2), of length N and Hamming weight W. Rank the codewords of symbols 21 in lexicographic order (left to right). Let us consider the codewords $\{x_{n-1}; x_{n-2}... x_0\}$ of $n \le N$ symbols, containing w ones (w = 1...W). Let $C_{n,w}$ be the number of such codewords where w = number of ones. We have $C_{n,n+1} = 0$ (by definition) and $C_{n,1} = n$ (by inspection), and the recursion

$$C_{n,w} \; = \; C_{n-1,w} \; + \; C_{n-1,w-1}$$

n is a number of symbols of the codeword remaining to be decoded and w is a Hamming Weight of symbols of the codeword remaining to be decoded.

The route from the node equivalent to $C_{n-1,w}$ e.g. (n-1, w) to the destination equivalent to $C_{n,w}$ e.g. (n, w) is via a transition equivalent to an addition of "0" to the symbol sequence. The number of routes to the destination node via "0" is therefore $C_{n-1,w}$.

The route from the node equivalent to $C_{n-1,w-1}$ e.g. (n-1, w-1) to the destination equivalent to $C_{n,w}$ e.g. (n, w) is via the transition equivalent to an addition of "1" to the symbol sequence. The number of routes to the destination node via "1" is therefore $C_{n-1,w-1}$.

As the symbol sequence is a binary sequence there are no other routes to the destination.

Therefore the total number of routes to the destination is therefore $C_{n-1,w} + C_{n-1,w-1}$.

$$C_{n,w} \; = \; \binom{n}{w} = \frac{n!}{w!\,(n-w)!}$$

and the following relation holds

$$\binom{n}{w} = \binom{n-1}{w} + \binom{n-1}{w-1}$$

The route through a codeword trellis needs to accurately identify the position of each "1" in the symbol sequence. Each progression of a route through the trellis via addition of a "1" or "0" to the symbol sequence at position n-1 increases n by 1 to n. Each progression of a route through the trellis via addition of a "1" to the symbol sequence at position n-1 increases w by 1 thus the route jumps from node (n-1, w-1) to node (n,w). Each progression of a route through the trellis via addition of a "0" to the symbol sequence at position n-1 leaves w unchanged thus the route jumps from node (n-1, w) to node (n,w).

Suppose that we already have indexing rules to enumerate the two types of sequences of length n-1, with indices from 0 to $C_{n-1,w}$-1 for the route to the node (n-1, w), and from 0 to $C_{n-1,w-1}$-1 for the route to the node (n-1, w-1).

If the sequences of length n has the leftmost bit equal to "0", it can be enumerated with the indices from 0 to $C_{n-1,w}$-1 as there is no requirement to locate a "1".

If the sequences of length n has the leftmost bit equal to "1", it requires a range of at least $C_{n-1,w-1}$ indices to locate w-1 "1"s at one of n-1 positions within a sequence of n symbols. It can be enumerated with the indices from $C_{n-1,w}$ to $C_{n-1,w}$+ $C_{n-1,w-1}$-1 = $C_{n,w}$, i.e., we add $C_{n-1,w}$ to the index of the block of length n-1. The index contains the term $C_{n-1,w}$ only if there is a one in position n-1.If we apply this rule recursively, each index is thus computed as a sum of binomial coefficients.

The binomial coefficients $C_{n,w}$ can be found from Pascal's triangle:

Pascal triangle:                    w=1

n=0                              1       0       w=2

n=1                           1       1       0       w=3

n=2                        1       2       1       0       w=4

n=3                     1       3       3       1       0       w=5

n=4                  1       4       6       4       1       0       w=6

n=5               1       5       10       10       5       1       0

n=6            1       6       15       20       15       6       1       0

n=7         1       7       21       35       35       21       7       1

n=8      1       8       28       56       70       56       28       8       1

The look-up table of binomial coefficients for fixed composition (de)matching is

Table: 1

| $C_{n,w}$ | w=1 | 2 | 3 |
|---|---|---|---|
| n=0 | 0 | | |
| 1 | 1 | 0 | |
| 2 | 2 | 1 | 0 |
| 3 | 3 | 3 | 1 |
| 4 | 4 | 6 | 4 |
| 5 | 5 | 10 | 10 |
| 6 | | 15 | 20 |
| 7 | | | 35 |

Each symbol $S_j$ e.g. "1" in the symbol codeword 21 has an associated additive term. The additive term $C_{n,w}$ is dependent upon the total number of those symbols $S_j$ e.g. "1"s remaining to be decoded in the codeword w, and upon the position n of the current symbol $S_j$ e.g. "1" being decoded in the codeword (This is dependent upon an amount of symbols (n) of the codeword remaining to be decoded). The index is the sum of the additive terms for the codeword.

EP 3 767 457 A1

Table:2

| codeword trellis | x codeword | W | additive terms of index (binomial term $C_{n,wn,w}$ n=3...0 w=4...1) | | | | index (W=4) | index (W=3) | index (W=2) | index (W=1) |
|---|---|---|---|---|---|---|---|---|---|---|
| 1111 | 1 1 1 1 | 4 | $C_{3,4}=0$ | $C_{2,3}=0$ | $C_{1,2}=0$ | $C_{0,1}=0$ | 0 | | | |
| 111 1110 | 1 1 1 0 | 3 | $C_{3,3}=1$ | $C_{2,2}=1$ | $C_{1,1}=1$ | | | 3 | | |
| 11 1101 | 1 1 0 1 | 3 | $C_{3,3}=1$ | $C_{2,2}=1$ | | $C_{0,1}=0$ | | 2 | | |
| 110 1100 | 1 1 0 0 | 2 | $C_{3,2}=3$ | $C_{2,1}=2$ | | | | | 5 | |
| 1 1011 | 1 0 1 1 | 3 | $C_{3,3}=1$ | | $C_{1,2}=0$ | $C_{0,1}=0$ | | 1 | | |
| 101 1010 | 1 0 1 0 | 2 | $C_{3,2}=3$ | | $C_{1,1}=1$ | | | | 4 | |
| 10 1001 | 1 0 0 1 | 2 | $C_{3,2}=3$ | | | $C_{0,1}=0$ | | | 3 | |
| 100 1000 | 1 0 0 0 | 1 | $C_{3,1}=3$ | | | | | | | 3 |
| 0111 | 0 1 1 1 | 3 | | $C_{2,3}=0$ | $C_{1,2}=0$ | $C_{0,1}=0$ | | 0 | | |
| 011 0110 | 0 1 1 0 | 2 | | $C_{2,2}=1$ | $C_{1,1}=1$ | | | | 2 | |
| 01 0101 | 0 1 0 1 | 2 | | $C_{2,2}=1$ | | $C_{0,1}=0$ | | | 1 | |
| 010 0100 | 0 1 0 0 | 1 | | $C_{2,1}=2$ | | | | | | 2 |
| 0 001 0011 | 0 0 1 1 | 2 | | | $C_{1,2}=0$ | $C_{0,1}=0$ | | | 0 | |
| 0010 | 0 0 1 0 | 1 | | | $C_{1,1}=1$ | | | | | 1 |
| 00 000 001 | 0 0 0 1 | 1 | | | | $C_{0,1}=0$ | | | | 0 |
| 000 | 0 0 0 0 | 0 | | | | | | | | |

14

The index value is a unique value for each different combination of a number of symbols of the codeword remaining to be decoded (n) and a Hamming Weight (w) of symbols of the codeword remaining to be decoded.

Referring to **FIG 3**, the matcher 20 performs matching algorithm 110.

At block 112, the algorithm variables I, n, w are declared.

I = i(x) = the integer index determined by binary-to-decimal conversion of the block of Nb binary bits 10

n = N-1, where N is the length of the symbol codeword x

w = W, where W is the fixed Hamming weight of the symbol codeword x (for constant composition matching)

The algorithm additionally uses $x_n$ which is a value of binary symbol at position n in the codeword x, and uses $C_{n,w}$ which is the binomial coefficient from look-up table. For instance Table 1 for the case of n=7 w=3.

At block 114, read the value of the binomial coefficient $C_{n,w}$ from look-up Table 1. If the value of $C_{n,w}$ is greater than I then the process moves to block 116. However, if the value of $C_{n,w}$ is less than or equal to I then the process moves to block 118.

At block 116, the value $x_n$ of binary symbol at position n in the codeword x is set to zero ("0"). The value n identifying a bit position in the codeword x is decremented by 1.

At block 118, the value $x_n$ of binary symbol at position n in the codeword x is set to one ("1"). The value n identifying a bit position in the codeword x is decremented by 1. The value w that represents the Hamming Weight of the remaining symbols of codeword x to be found, is decreased by 1. The value I that represents the index for the remaining symbols of codeword x to be found, is decreased by the binomial coefficient $C_{n,w}$.

At block 120, if the last binary symbol of the codeword has been determined the method ends. Otherwise the method iterates, returning to block 114.

The method 110 comprises iterating:

if a current index I for a current bit at position n is less than a current threshold $C_{n,w}$, set a bit $x_n$ at the current bit position n to zero,

determine a new threshold $C_{n-1, w}$ using a new bit position (n-1) and the current Hamming Weight,

change the current bit position n to the new bit position (n-1),

replace the current threshold with the new threshold $C_{n-1, w}$

otherwise if a current index I for a current bit at position n is greater than or equal to the current threshold $C_{n,w}$, set the bit $x_n$ at the current bit position n to one,

create a new index (I:=I-$C_{n,w}$) by subtracting the threshold $C_{n,w}$ from the current index I,

create a new Hamming Weight (w-1) by subtracting one from a current Hamming weight;

determine a new threshold $C_{n-1, w-1}$ using a new bit position (n-1) and the new Hamming Weight (w-1),

change the current bit position n to a new bit position (n-1), and

replace the current index with the new index, the current threshold with the new threshold and the current Hamming Weight with the new Hamming weight.

Referring to the binomial table (Table: 1), starting from the last row n=N-1 in the column w=W, and decreasing n, we look for the first binomial coefficient $C_{n_1,w}$ (in column w=W) that is less than or equal to I. This entry identifies the position $n_1$ of the first 1 in the sequence x. We subtract $C_{n_1,w}$ from I, namely

$$I := I - C_{n_i,W}$$

and we repeat the search, looking for the first row $n_2$, in the column w=W-1, such that $C_{n_2,W-1} \le I$. We recursively apply the procedure until we reach I=0 and we have identified all W of the "1" positions, $n_1, n_2 ... n_W$.

Referring to **FIG 4A**, the de-matcher 60 performs de-matching algorithm 130.

At block 132, the algorithm variables i(x), n, w are declared.

i(x) = the integer index is initial set to zero.

n = N-1, where N is the length of the symbol codeword x

w = W, where W is the fixed Hamming weight of the symbol codeword x (for constant composition matching)

The algorithm additionally uses $x_n$ which is a value of binary symbol at position n in the codeword x, and uses $C_{n,w}$ which is the binomial coefficient from look-up Table 1.

At block 134, read the value $x_n$ of the of binary symbol at position n in the codeword x. If the value $x_n$ of the of binary symbol at position n in the codeword x is "1" then the method moves to block 136. If the value $x_n$ of the of binary symbol at position n in the codeword x is "0" then the method moves to block 138.

At block 136, the integer index i(x) is increased by the binomial coefficient $C_{n,w}$ from Table 1 and the current remaining Hamming Weight w is decreased by 1. The method moves to block 138.

At block 138, the value n identifying a bit position in the codeword x is decremented by 1.

At block 140, if the last binary symbol of the codeword has been processed the method ends outputting the value i(x) 23. Otherwise the method iterates, returning to block 134.

FIG 4A illustrates another example of the method 60 illustrated in FIG 4A. In FIG 4A, the method 60 is applied in forward bit-order (from last to first codeword bit). In FIG 4B, the method 60 is applied in reverse bit-order (from first to last codeword bit). The method 60 illustrated in FIG 4B can, for example, be a preferred approach when using truncated arithmetic. The look-up table of $C_{n,w}$ values can be untruncated or truncated (as described below). The differences between FIG 4A and FIG 4B are that, in FIG 4B, at block 132 the algorithm variables n, w are declared as value *"0"*, at block 136 the current remaining Hamming Weight w is increased by 1, at block 138 the value n identifying a bit position in the codeword x is incremented by 1, and at block 140, if the *first* binary symbol of the codeword has been processed the method ends outputting the value i(x) 23.

The method 110 comprises iterating:

if a value $x_n$ of the of binary symbol at position n in the codeword x is "1" increase the current index i(x) by $C_{n,w}$, and create a new Hamming Weight (w-1) by subtracting one from a current Hamming weight,

then

change the current bit position n to a new bit position (n-1).

If a constant weight sequence x = {$x_{N-1}$; $x_{N-2}...x_0$} has W ones in positions $n_1 > n_2...n_W$.

The lexicographic index i(x) of the sequence x is calculated as

$$i(x) = \binom{n_1}{W} + \binom{n_2}{W-1} + \cdots \binom{n_W}{1}$$

To encode the sequence x the entries $C_{n,w}$ of the binomial look-up table are used

$$i(x) = C_{n_1,W} + C_{n_2,W-1} + \cdots C_{n_W,1}$$

We can use this formula to build a look-up table to map integer indices i(x) to symbol codewords x 21 and vice-versa.

Example of process at matcher 20 for creating codeword x 21 for transmission.

Let the binary bit sequence be: 1011, N=8, W=3

$$i(x) = 1*2^0 + 1*2^1 + 0*2^2 + 1*2^3 = 1+2+8=11$$

$C_{n_1,3}$ = 10 returns $n_1$ = 5. I = 11 - 10 = 1.
$C_{n_2,2}$ = 1 returns $n_2$ = 2. I = 1 - 1 = 0.
$C_{n_3,1}$ = 0 returns $n_3$ = 0.
x = 0 0 1 0 0 1 0 1 (ones at $n_1$ = 5, $n_2$ = 2, $n_3$ = 0)

The equivalent process at de-matcher 20 after receiving codeword x 21.
Let x = 0 0 1 0 0 1 0 1.
W=3, N=8

$$i(x) = C_{5,3} + C_{2,2} + C_{0,1} = 10 + 1 + 0 = 11$$

dec2bin (11) to recover the binary bit sequence 10 namely: 1011

The above-described algorithms 110, 130 are particularly suited for implementation in digital logic with a large degree of parallelism (as typically happens in very high rate optical applications).

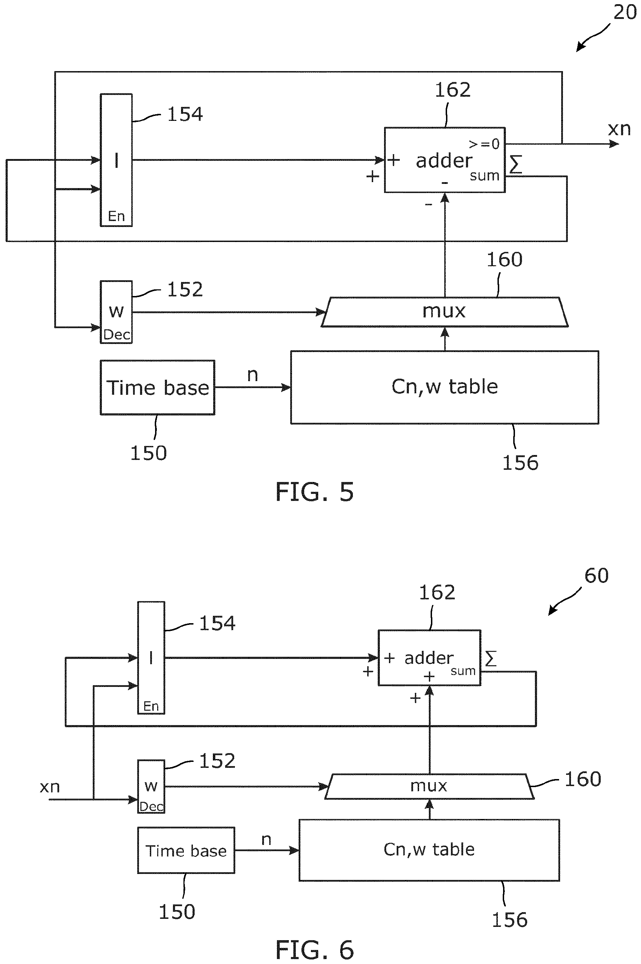

**FIG** 5 illustrates an example of a matcher 20. The matcher 20 is implemented in hardware configured to perform the method 110. The hardware can comprise application specific circuitry (ASICs).

The matcher uses a current Hamming Weight (w) and a current index value (I) as state variables, and a current bit position (n) in the codeword (x) as time-base running through each bit position in the codeword e.g. from N-1 down to 0.

For a position n in a codeword x, the symbols at positions N-1, N-2...N-n have been determined, the remaining symbols at positions N-n-1, N-n-2...1, 0 are yet to be determined.

The value w represents the Hamming Weight of the remaining symbols in the codeword x 21 that are yet to be determined.

The value I represents the index i(x) for the remaining symbols in the codeword x 21 that are yet to be determined.

Initially n=N-1, w=W and I=i(x). The value of i(x) is the value 23 determined from the bit sequence 10. These values are written to the respective registers 150, 152, 154 and are used to determine each bit $x_n$ of a codeword x.

A first register 150 is used to store the current value of n. The value n is a pointer to a current bit position in the codeword. This value is decremented by 1 with each clock cycle from an initial value of N-1 to 0.

A second register 152 is used to store the current value of Hamming Weight (w). This is the Hamming Weight of the remaining symbols in the codeword from bit position n to bit position 0 that are yet to be determined. This value is decremented by 1 whenever a "1" is found in the codeword at the current bit position n determined by the first register 150.

A third register 154 is used to store the current index value I. This is the index i(x) for the remaining symbols in the codeword from bit position n to bit position 0 that are yet to be determined. This value is decremented by $C_{n,w}$ whenever a "1" is found in the codeword at the current bit position n determined by the first register 150.

A look-up table of coefficients values $C_{n,w}$ is stored in memory 156. There are values for at least the combinations of n=0, 1, 2...N-1 and w=0, 1..W. The memory 156 can be any suitable memory. It can for example be a RAM or ROM memory.

The look-up table of $C_{n,w}$ values can be based on enumerative coding. For example they may be based on constant composition enumerative encoding as illustrated in Table 1. In other examples they may be based on variable composition enumerative coding (as described below). The look-up table of $C_{n,w}$ values can be based on enumerative coding and can be untruncated or truncated (as described below).

The value of n from the register 150 addresses a set {$C_{n,w}$} of multiple coefficients $C_{n,w}$ that have the same n but different w. A particular one of the coefficients $C_{n,w}$, in the set of multiple coefficients {$C_{n,w}$} is selected by the value of w provided to the multiplexer by the register 152. The selected one of the coefficients $C_{n,w}$ is the coefficient that corresponds to the current value of the current bit position n from the first register 150 and the current value of the current Hamming Weight (w) provided by the second register 152.

For example, a complete row in the table can be selected by the current value of the current bit position n (provided from the first register 150) and be provided to the multiplexer 160. A column value w, within that row n, is selected by the value of the current Hamming Weight (w) provided by the second register 152 as a selection input to the multiplexer 160.

The output of the multiplexer 160 to the adder logic 162 is therefore the value $C_{n,w}$ where n is defined by the first register 150 and w is defined by the second register 152.

The adder logic 162 is configured to determine a condition based on I- Cn,w (e.g. I-Cn,w ≥0), where Cn,w is the coefficient provided from a memory 156 and I is the current index value provided by the third register 154. When the condition is satisfied the adder logic is configured to identify a symbol for the codeword at the current bit position and cause updating of the second register 152 for w and the third register 156 for I. Updating the third register 156 comprises writing an updated index value I-Cn,w based on the determined condition to the second register 152.

The adder logic 162 is configured to determine I- $C_{n,w}$. If I< $C_{n,w}$ then $x_n$ is given the value "0" and there is no change to the registers 152, 154. If I≥ $C_{n,w}$ then $x_n$ is given the value "1", the value I- $C_{n,w}$ is read into the register 154 and the register 152 is updated by reducing its current value by 1.

FIG 6 illustrates an example of a de-matcher 20. The de-matcher 20 is implemented in hardware configured to perform the method 110. The hardware can comprise application specific circuitry (ASICs).

The de-matcher uses a current Hamming Weight (w) and a current index value (I) as state variables, and a current bit position (n) in the codeword (x) as time-base running through each bit position in the codeword e.g. from N-1 down to 0 (this corresponds to the example of method 60 illustrated in FIG 4A).

For a position n in a codeword x, the symbols at positions N-1, N-2...N-n have been processed to determine the current index, the remaining symbols at positions N-n-1, N-n-2...1, 0 are yet to be processed.

The value w represents the Hamming Weight of the remaining symbols in the codeword x 21 that are yet to be processed.

The value I represents the index i(x) for the remaining symbols in the codeword x 21 that are yet to be processed.

The algorithm variables I, n, w are declared. In this example the algorithm variables are initially declared as n=N-1, w=W and I=0. These values are written to the respective registers 150, 152, 154. The bits $x_n$ of the codeword x are provided as inputs. The output is the ultimate value of I=i(x) in the register 154.

A first register 150 is used to store the current value of n. The value n is a pointer to a current bit position in the codeword. This value is changed by 1. In this example, it is decremented by 1 with each clock cycle from an initial value of N-1 to 0.

A second register 152 is used to store the current value of Hamming Weight (w). This is the Hamming Weight of the remaining symbols in the codeword from bit position n to bit position 0 that are yet to be processed. This value is changed by 1. In this example, it is decremented by 1 whenever a "1" is found in the codeword at the current bit position n determined by the first register 150.

A third register 154 is used to store the current index value I. This is the index i(x) for the remaining symbols in the codeword that are yet to be processed. In this example, the remaining symbols in the codeword that are yet to be processed are from bit position n to bit position 0. This value is incremented by $C_{n,w}$ whenever a "1" is found in the codeword at the current bit position n determined by the first register 150. While in this example the de-matcher 20 performs the example of method 60 illustrated in FIG 4A, it can be simply adapted to perform the method of FIG 4B. The algorithm variables n, w are declared as value "0", the current remaining Hamming Weight w is increased by 1 not decreased by 1, the value n identifying a bit position in the codeword x is incremented by 1 each clock cycle not decremented.

A table of coefficients values $C_{n,w}$ is stored in memory 156. There are values for at least the combinations of n=0, 1, 2...N-1 and w=0, 1..W. The memory 156 can be any suitable memory. It can for example be a RAM or ROM memory.

The table of $C_{n,w}$ values can be based on enumerative coding. For example they may be based on constant composition enumerative encoding as illustrated in Table 1. In other examples they may be based on variable composition enumerative coding (as described below). The table of $C_{n,w}$ values can be based on enumerative coding can be untruncated or truncated (as described below).

The value of n from the register 150 addresses a set $\{C_{n,w}\}$ of multiple coefficients $C_{n,w}$ that have the same n but different w. A particular one of the coefficients $C_{n,w}$, in the set of multiple coefficients $\{C_{n,w}\}$ is selected by the value of w provided to the multiplexer by the register 152. The selected one of the coefficients $C_{n,w}$ is the coefficient that corresponds to the current value of the current bit position n from the first register 150 and the current value of the current Hamming Weight (w) provided by the second register 152.

For example, a complete row in the table can be selected by the current value of the current bit position n (provided from the first register 150) and be provided to the multiplexer 160. A column value w, within that row n, is selected by the value of the current Hamming Weight (w) provided by the second register 152 as a selection input to the multiplexer 160.

The output of the multiplexer 160 to the adder logic 162 is therefore the value $C_{n,w}$ where n is defined by the first register 150 and w is defined by the second register 152.

The adder logic 162 is configured to determine I+ $C_{n,w}$ where $C_{n,w}$ is the coefficient provided from a memory 156 and I is the current index value provided by the third register 154.

If $x_n$ has the value "1", the sum I+ $C_{n,w}$ is read into the register 154 and the value of w in the register 152 is changed by 1, for example decremented by 1.

If $x_n$ has the value "0", the sum I+ $C_{n,w}$ is not read into the register 154 (the value in the register is unchanged) and the value of w in the register 152 is not changed (e.g. not decremented) by 1 (the value in the register 152 is unchanged).

The same circuitry (registers 150, 152, 154; memory table 156; multiplexer 160 and adder logic 162) can be used for the matcher 20 and the de-matcher 60. The components can be the same and operate in the same way.

In both the matcher 20 and the de-matcher 60, adder logic 162 is configured to: determine an interim value based on a coefficient provided from the memory and the current index value, and cause updating of the second and third registers comprising writing an updated index value based on the interim value to the second register. The circuitry can be configured to operate as a matcher 20 or a de-matcher 60.

In the matcher 20 selected coefficient $C_{n,w}$ is subtracted (I- $C_{n,w}$) to create the interim value whereas in a de-matcher 60 the selected coefficient $C_{n,w}$ is added (I+ $C_{n,w}$) to create the interim value. Also whereas the matcher 20 receives as input the index value 23 (I=i(x)) and produces the codeword (x) 21, the de-matcher receives 60 as input the codeword (x) 21 and produces the index 23

In a matcher 20 the current index value in the third register 154 is decremented on output symbol determination whereas in a de-matcher 60 the current index value in the third index register 154 is incremented on input symbol identification.

For the matcher 20, the interim value I- $C_{n,w}$ is used to determine a symbol-dependent condition I- $C_{n,w} \geq 0$. When the condition is satisfied the adder logic 162 is configured to cause updating of the second and third registers 152, 154 comprising writing an updated index value (I:= I- $C_n$) based on the determined condition to the third register 156 and determine a symbol for the codeword at the current bit position. When the updated index value is based on the current index value minus the coefficient provided from the memory. The condition is that the current index value minus the coefficient provided from the memory is greater than or equal to zero.

For the de-matcher 60, an identification of a particular symbol at the current bit position is used to determine a symbol-dependent condition. When the condition is satisfied the adder logic 162 is configured to cause updating of the second and third registers 152, 154 comprising writing an updated index value I+ $C_{n,w}$ to the third register. The updated index value is dependent upon on the determined condition because $C_{n,w}$ is dependent upon the particular symbol. For example in FIG 4A when the particular symbol is "0" the the second and third registers 152, 154 are not updated- the coefficient $C_{n,w}$ is zero valued, however, when the particular symbol is "1" the the second register 152 has its value decremented by 1 and the third register 154 is updated using I+ $C_{n,w}$ where $C_{n,w}$ is provided from the memory 156. The updated index value I+ $C_{n,w}$ is based on the current index value plus a symbol-dependent coefficient dependent upon one or more coefficients provided from the memory.

The hardware architecture described above for the matcher 20 and de-matcher 60 has a number of advantages.

For a definite set of parameters (N, W), the number Nb of input bits used to produce the index i(x) and the number N of symbols in the codeword x are fixed. E.g. for N=8, W=3 there are 8!/5!3!= 56 codewords maximum, so Nb is $\log_2(56)$=5 bits. Consequently, in 8 clock cycles, the matcher circuit 20 receives 5 input bits from data 10 and generates 8 output bits of codeword 21, one per clock cycle: this simplifies a lot the handling of input and output buffers, as the data stream is extremely regular. Given that the matcher circuit 20 generates one bit per clock cycle, there can be many identical matcher circuits 20 in parallel when the data-stream 10 has a certain degree of parallelism (e.g. 128 or 256 bits wide).

The many parallel matcher circuits can share the time-base. They may for example share the same register 150.

The look-up table 156 can be shared, as its output is needed at the same time by all the parallel matcher circuits 20.

Changing the parameters (N, W) of the matcher is simply a matter of changing the initialization of the register 150 (for n) and the register 152 (for w) in the circuit 20.

The look-up table 156 for $C_{n,w}$ is unique, and different N, W settings use different subsets of the table. E.g. if we want to run a N=5, W=2 matcher, we simply initialize the register 150 (for n) to 5 and the register 152 (for w) to 2. The encoding cycle will now last 5 clock cycles, but the rest remains unchanged.

**Variable Composition**

The above described enumerative coding can be used for indexing more generally constrained sequences. Let us consider, for instance, binary sequences of length N and weight W or W-1. It can be shown that we have only to replace the binomial coefficients $C_{n,w} = \binom{n}{w}$ with $C_{n,w} = \binom{n}{w} + \binom{n}{w-1}$. $C_{n,w}$ We could evaluate the tables of binomials for W and W-1, and sum them creating a cumulative Pascal triangle where $C_{n,1} = \binom{n}{1} + \binom{n}{0} = n + 1$

$$
\begin{array}{ccccccccc}
 & & & & 1 & & & & \\
 & & & 1 & & 2 & & & \\
 & & 1 & & 3 & & 4 & & \\
 & 1 & & 4 & & 7 & & 8 & \\
1 & & 5 & & 11 & & 15 & & 16 \\
\end{array}
$$

1 6 16 26 31 32
1 7 22 42 57 63 64
1 8 29 64 99 120 127 128
1 9 37 93 163 219 247 255 256

The binomial coefficients $C_{n,w}$ can be found from extending the Cumulative Pascal triangle:

```
w=                    1   2   3   4   5   6

n=1                1   1   1   1   1   1   1

n=2             1   2   2   2   2   2   2

n=3          1   3   4   4   4   4   4

n=4       1   4   7   8   8   8   8

n=5    1   5   11  15  16  16  16

n=6  1   6   16  26  31  32  32

n=7  1   7   22  42  57  63  64

n=8  1   8   29  64  99  120 127 128

n=9  1   9   37  93  163 219 247 255 256
```

The table of binomial coefficients $C_{n,w}$ for variable composition (de)matching is

Table: 3

| $C_{n,w}$ | w=1 | 2 | 3 |
|---|---|---|---|
| n=0 | 1 | 1 | 1 |
| 1 | 2 | 2 | 2 |
| 2 | 3 | 4 | 4 |
| 3 | 4 | 7 | 8 |
| 4 | 5 | 11 | 15 |
| 5 | 6 | 16 | 26 |
| 6 | | 22 | 42 |
| 7 | | | 64 |

An alternative approach is to observe that the recursion

$$C_{n,w} = C_{n-1,w} + C_{n-1,w-1}$$

still holds. Thus the table can be filled by recursion, with a different initialization, namely

$$C_{n,1} = \binom{n}{1} + \binom{n}{0} = n + 1.$$

The matcher can be further generalized to produce a sequence with any range of Hamming weights. For instance, if we accept any binary sequence of Hamming weight 0,1,2,...,W we just need to initialize $C_{n,1}$ = n + 1 and

$$C_{0,w} = \binom{0}{W} + \cdots \binom{0}{1} + \binom{0}{0} = 1$$ and fill the table using the recursion

$$C_{n,w} = C_{n-1,w} + C_{n-1,w-1}$$

Example. Let N=8, W=3. The number of sequences we need to index is $\binom{8}{3} + \binom{8}{2} +$

$$\binom{8}{1} + \binom{8}{0} = 56 + 28 + 8 + 1 = 93.$$ The table of binomial coefficients, filled as described above is given in Table 3.

Example of process at matcher 20 for creating codeword x 21 for transmission.

Let the binary bit sequence be: 11011, N=8, W=3

$$i(x) = 1*2^0 + 1*2^1 + 0*2^2 + 1*2^3 + 1*2^3 = 1+2+8+16=27$$

Following the method described in FIG 3 and in relation to circuitry 20 of FIG 5:

$C_{n_1,3} = 26$ returns $n_1 = 5$. I = 27 - 26 = 1. w=2
$C_{n_2,2} = 1$ returns $n_2 = 0$. I = 1 - 1 = 0.
Since there is no $C_{n_3,1} \leq$ I = 0, there is not another one.
x = 0 0 1 0 0 0 0 1 (ones at $n_1 = 5$, $n_2 = 0$)

It should be noted that the codeword has a Hamming Weight of 2 which satisfies the constraint of variable composition, namely a Hamming Weight less than or equal to W, which is three in this example.

The equivalent process at de-matcher 20 after receiving codeword x 21.

Let x = 0 0 1 0 0 0 0 1.

W=3, N=8

Following the method described in FIG 4A and in relation to circuitry 60 of FIG 6:

$$i(x) = C_{5,3} + C_{0,2} = 26 + 1 = 27$$

dec2bin (27) to recover the binary bit sequence 10 namely: 11011

The hardware matcher circuit 20 is exactly the same as in the previous example (FIG 5) only the memory table 156 needs to have different binomial coefficients $C_{n,w}$. The hardware matcher circuit 60 is exactly the same as in the previous example (FIG 6) only the memory table 156 needs to have different binomial coefficients $C_{n,w}$. The matcher 20 and de-matcher 60 pair use the same coefficients $C_{n,w}$.

The memory table 156 can be configured to be updatable so that the coefficients $C_{n,w}$ can be updated.

Matching 110 using variable composition coefficients $C_{n,w}$ achieves a smaller rate loss for any fixed block length, or the same rate loss with much smaller block lengths with respect to constant composition coefficients $C_{n,w}$.

**Truncation**

The binomial coefficients $C_{n,w}$ are stored in a look-up table. However, if N is large, large tables containing extremely large numbers are required. To save space, a smaller subset of integers is used by truncating the binomial coefficients $C_{n,w}$. The binomial coefficients $C_{n,w}$ are represented as integers using a fixed number of bits (b) of mantissa and a variable number of bits (a) of exponent. We represent binary numbers like

$$\underbrace{xxx \ldots x}_{b} 00 \ldots 0$$

Let $\hat{C}_{n,w}$ be the truncated binomial coefficients. We can enumerate only $\hat{C}_{n-1,w}$ and $\hat{C}_{n-1,w-1}$ sequences having a zero or a one in position n-1, respectively. To be able to enumerate $\hat{C}_{n,w}$ sequences of length n we have

$$\hat{C}_{n,w} \leq \hat{C}_{n-1,w} + \hat{C}_{n-1,w-1}$$

Besides, $\hat{C}_{n,w}$ is one of the integer values that we can represent. Therefore, for the truncated coefficients we obtain the recursion

$$\hat{C}_{n,w} = t\left( \hat{C}_{n-1,w} + \hat{C}_{n-1,w-1} \right)$$

where $t(c)$ is the function that truncates $c$ to the nearest allowed value.

The matcher 20 and the de-matcher 60 use exact arithmetic, with operands taken from the look-up table of truncated binomials $\hat{C}_{n,w}$. Since the mathematics is exact, the de-matcher 20 can sum the truncated binomials in any order. The matcher 20 starts subtracting the binomials in the last column of the look-up table. Exact arithmetic is considerably simplified by the short mantissa.

Example. Let N=8, W=3, b=3. The allowed values of the truncation function are any value up to $2^b$, 8 in this example, and then truncation starts allowing (1010)=10, (1100)=12, (1110)=14, (10000)=16, (10100)=20, (11000)=24, (11100)=28, (100000)=32... The table of truncated binomial coefficients is the same as in the previous example but for $\hat{C}_{7,3} = t(\hat{C}_{6,3} + \hat{C}_{6,2}) = t(20 + 15) = t(35) = t(100011)_2 = (100000)_2 = 32$, and $\hat{C}_{6,2} = t(\hat{C}_{5,2} + \hat{C}_{5,1}) = t(10 + 5) = t(15) = t(1111)_2 = (1110)_2 = 14$ and $\hat{C}_{6,3} = t(\hat{C}_{5,3} + \hat{C}_{5,2}) = t(10 + 10) = t(20) = t(10100)_2 = (10100)_2 = 20$

Therefore Table 1 for constant composition

| $C_{n,w}$ | w=1 | 2 | 3 |
|-----------|-----|----|----|
| n=0 | 0 | | |
| 1 | 1 | 0 | |
| 2 | 2 | 1 | 0 |
| 3 | 3 | 3 | 1 |
| 4 | 4 | 6 | 4 |
| 5 | 5 | 10 | 10 |
| 6 | | **15** | 20 |
| 7 | | | **35** |

becomes

Table 4

| $C_{n,w}$ | w=1 | 2 | 3 |
|-----------|-----|----|----|
| n=0 | 0 | | |
| 1 | 1 | 0 | |
| 2 | 2 | 1 | 0 |
| 3 | 3 | 3 | 1 |
| 4 | 4 | 6 | 4 |
| 5 | 5 | 10 | 10 |
| 6 | | **14** | 20 |
| 7 | | | **32** |

The Table 3 for variable composition

| $C_{n,w}$ | w=1 | 2 | 3 |
|-----------|-----|----|----|
| n=0 | 1 | 1 | 1 |
| 1 | 2 | 2 | 2 |
| 2 | 3 | 4 | 4 |
| 3 | 4 | 7 | 8 |
| 4 | 5 | 11 | 15 |

(continued)

| $C_{n,w}$ | w=1 | 2 | 3 |
|---|---|---|---|
| 5 | 6 | 16 | 26 |
| 6 | | 22 | 42 |
| 7 | | | 64 |

becomes

Table 5

| $\hat{C}_{n,w}$ | w=1 | 2 | 3 |
|---|---|---|---|
| n=0 | 1 | 1 | 1 |
| 1 | 2 | 2 | 2 |
| 2 | 3 | 4 | 4 |
| 3 | 4 | 7 | 8 |
| 4 | 5 | **10** | **14** |
| 5 | 6 | **14** | **24** |
| 6 | | **20** | **32** |
| 7 | | | **48** |

The maximum index, corresponding to the sequence 11100000, is 48+20+6=74. We can enumerate 75 sequences, instead of 93 (64+22+6 +1, from Table 3)

Pascal triangle with b=2 digits mantissa:

$$1$$
$$1 \quad 1$$
$$1 \quad 2 \quad 1$$
$$1 \quad 3 \quad 3 \quad 1$$
$$1 \quad 4 \quad 6 \quad 4 \quad 1$$
$$1 \quad \mathbf{4} \quad \mathbf{8} \quad \mathbf{8} \quad \mathbf{4} \quad 1$$
$$1 \quad \mathbf{4} \quad \mathbf{12} \quad \mathbf{16} \quad \mathbf{12} \quad \mathbf{4} \quad 1$$
$$1 \quad \mathbf{4} \quad \mathbf{16} \quad \mathbf{24} \quad \mathbf{24} \quad \mathbf{16} \quad \mathbf{4} \quad 1$$
$$1 \quad \mathbf{4} \quad \mathbf{16} \quad \mathbf{32} \quad \mathbf{48} \quad \mathbf{32} \quad \mathbf{16} \quad \mathbf{4} \quad 1$$

Cumulative Pascal triangle with 2 digits mantissa:

$$1$$

$$1 \quad 2$$

$$1 \quad 3 \quad 4$$

$$1 \quad 4 \quad 6 \quad 8$$

$$1 \quad 4 \quad 8 \quad 12 \quad 16$$

$$1 \quad 4 \quad 12 \quad 16 \quad 24 \quad 32$$

$$1 \quad 4 \quad 16 \quad 24 \quad 32 \quad 48 \quad 64$$

$$1 \quad 4 \quad 16 \quad 32 \quad 48 \quad 64 \quad 96 \quad 128$$

$$1 \quad 4 \quad 16 \quad 48 \quad 64 \quad 96 \quad 128 \quad 192 \quad 256$$

Encoding (de-matcher)
Let x = 1 1 1 00000.

Decoding (matcher)
Let i(x)=74.

Example of process at matcher 20 for creating codeword x 21 for transmission.

Let the binary bit sequence be: 100110, N=8, W=3

$$i(x)= 1*2^6 + \; + 1*2^3 + 1*2^2 = 64+ 8 + 4 = 76$$

Following the method described in FIG 3 and in relation to circuitry 20 of FIG 5 but using the coefficients $C_{n,w}$ of Table 5:

$\hat{C}_{n1,3} = 48$ returns $n_1 = 7$. I = 74 - 48 = 26. w=2
$\hat{C}_{n2,2} = 20$ returns $n_2 = 6$. I = 26 - 20 = 6. w=1
$\hat{C}_{n3,1} = 6$ returns $n_3 = 5$.
x = 1 1 1 0 0 0 0 0 (ones at $n_1 = 7$, $n_2 = 6$, $n_3 = 5$)

The equivalent process at de-matcher 20 after receiving codeword x 21.
Let x = 1 1 1 0 0 0 0 0
W=3, N=8
Following the method described in FIG 4A and in relation to circuitry 60 of FIG 6 using $C_{n,w}$ of Table 5:

$$i(x) = \hat{C}_{7,3} + \hat{C}_{6,2} + \hat{C}_{5,1} = 48 + 20 + 6 = 74$$

dec2bin (74) to recover the binary bit sequence 10 namely: 100110.

The same hardware implementation as for previous embodiments (FIGs3&5 and 4&6) can be used. Different coefficients can be loaded into the memory table 156.

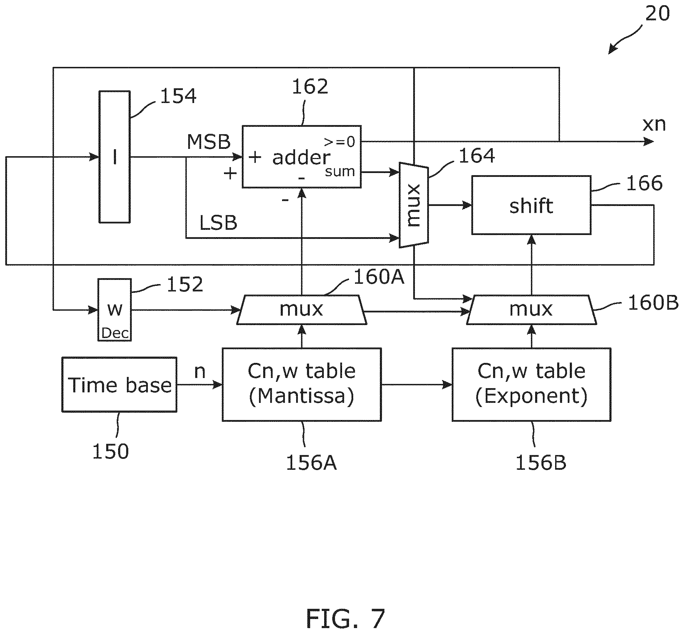

**FIG 7** illustrates a modified matcher 20 that operates in a manner similar to that illustrated in FIG 5. In this example, the memory table 156 is split into a memory table 156A and a memory table 156B.

The look-up table 156A, stored in a memory, is for the mantissa of the truncated coefficient. The look-up table 156B, stored in the same or different memory is for the exponent of the truncated coefficient.

The look-up table 156A and the look-up table 156B together represent the table of truncated coefficients.

The memory table 156A and the memory table 156B are addressed simultaneously by the vale n from the register 150. They provide the truncated coefficients for the provided n, that is they provide a row from the table of coefficients. The memory table 156A provides the mantissa of each coefficient in row n and the memory table 156B provides the exponent of each coefficient in the row n.

The adder logic 162 is not sized for the full width (size) of a coefficient, it is sized for just the mantissa.

The mantissa selected by w from register 152 using multiplexer 160A is subtracted from the relevant Most Significant Bits of I (which are, when the algorithm starts, the truncated expression of I), and combined at multiplexer 164 with the remaining Least Significant Bits that are unchanged. This operation correctly generates $x_n$, and is bit exact for the full I width (in case I is being updated). This reduces the adder size, which in turn enables high speed operations, and decouples the size of the adder logic 162 (depending on the mantissa) from the size of I (which can be huge in case of very long codewords).

Each clock cycle n is decrementing, and the current I value has to be confronted with the next line of the $C_{n,w}$ table, where possibly the exponents in the truncated coefficients are changing. This is taken into account by the (left) shift block 166, which is (left) shifting I in order to have the same exponent representation in ingress to the adder logic 162.

In particular the Exponent table 156B stores the Delta Exponent going from n to n-1; as this can depend also on the fact that w is kept or decremented (in turn depending on $x_n$), two Delta Exponent tables are stored, one for constant w and the other for decreasing w. The selection is further done via $x_n$, as indicated in the Fig.

A similar arrangement can be used for a de-matcher circuitry 60. The differences between to matcher circuit 20 using a split coefficient table 156A, 156B as illustrated in FIG 7 and a de-matcher circuit 60 using a split coefficient table 156A, 156B (not illustrated) are equivalent to the differences between matcher circuit 20 using a coefficient table 156 as illustrated in FIG 5 and a de-matcher circuit 60 using a coefficient table 156 as illustrated in FIG 6. The process at the de-matcher is executed in the reverse order with respect to the matcher 20. That means that it starts from the last $x_n$ transmitted, and not from the first one.

### Multi-level distribution matching

### Multinomial Matcher

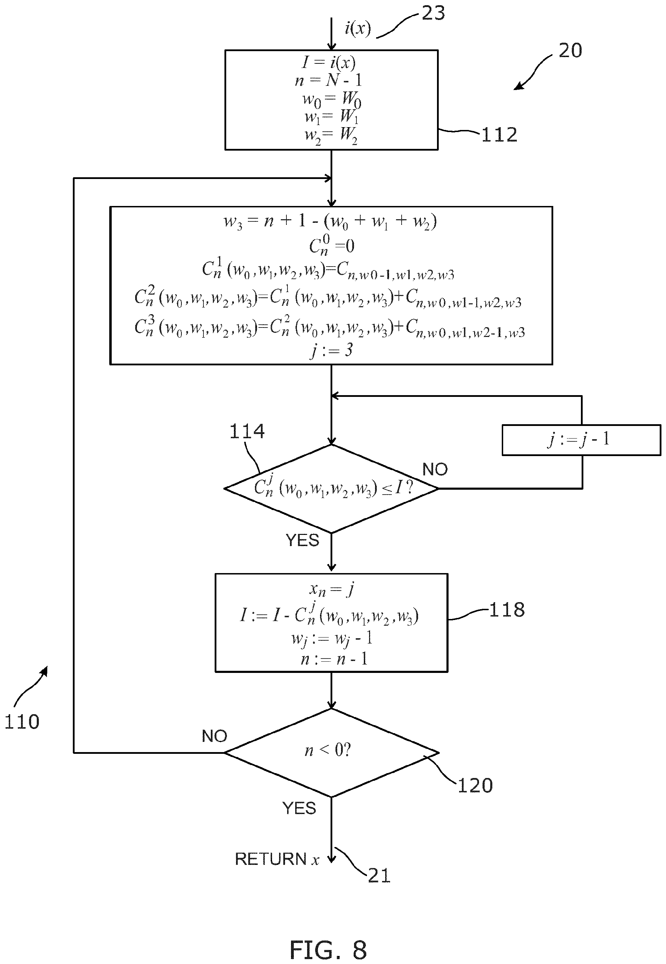

**FIG 8** illustrates a matcher 20 performing a matching algorithm 110 as previously described with reference to FIG 3. In the example of FIG 3, the alphabet of symbols used for the codeword x 21 is a binary alphabet (M=2). In the example of FIG 8, the alphabet of symbols used for the codeword x 21 is an alphabet M=4.

In this example, there is a Hamming weight $W_j$ in respect of each symbol $S_j$. The Hamming weight $W_j$ is the number of occurrences of the $S_j$ in the codeword x.

The value w is replaced by $w_j$ which is the number of occurrences of the symbol $S_j$ in the remainder of the codeword x. The initialization at block 132 defines a starting value for each $w_j$ as $W_j$.

The value $C_{n,w}$ is replaced by $C_n^j(w_1, w_2, w_3, w_4)$ where j is the index representing symbol $S_j$. The block 114 comprises a search through all j to find $C_n^j(w_1, w_2, w_3, w_4) \leq I$.

The block 118 is specific to a particular symbol Sj. It identifies the position n as symbol Sj and updates the Hamming Weight $w_j$ for symbol $S_j$.

The method can enumeratively decode the index value $I_n$ each clock cycle (each iteration) to obtain with each clock cycle (iteration) a symbol $S_n$ of the codeword 21 and conditionally, in dependence upon the obtained symbol $S_n$, obtain 118 a new index vale $I_{n-1}$ for enumeratively decoding at the next clock cycle (next iteration) to obtain the next symbol (n-1) of the codeword 21 The new index value new index vale $I_{n-1}$ is conditionally dependent upon $C_n^j(w_1, w_2, w_3, w_4)$ which is conditionally dependent upon the obtained symbol $S_j$.

In the example of FIG 3, the alphabet of symbols used for the codeword x 21 is a binary alphabet (M=2). If the symbol is logic zero, then index value is unchanged.

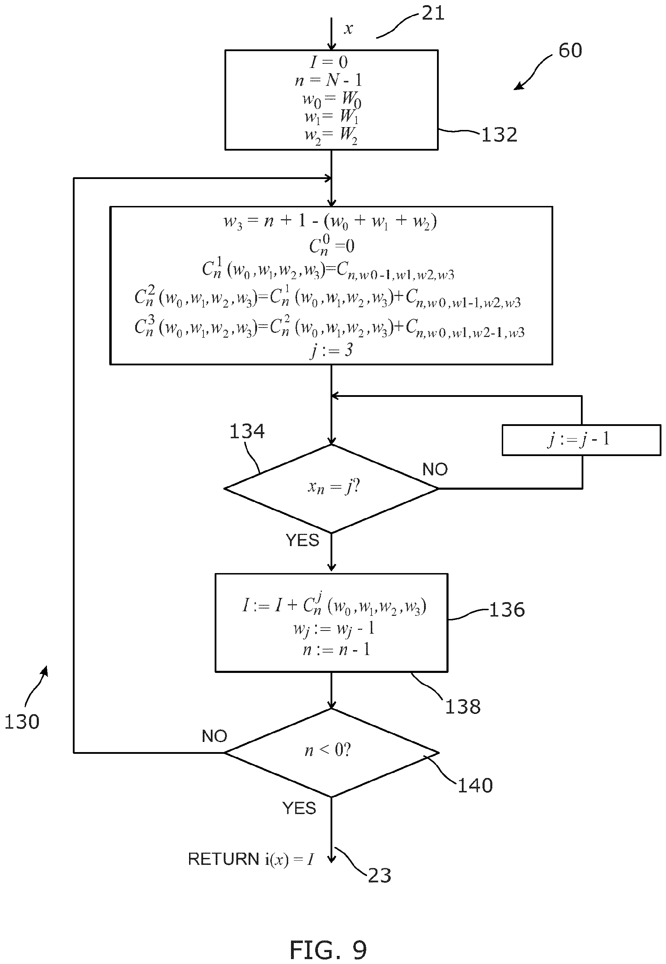

**FIG 9** illustrates a de-matcher 60 performing a de-matching algorithm 130 as previously described with reference to FIG 4A (or alternatively FIG 4B). In the example of FIG 4A, the alphabet of symbols used for the codeword x 21 is a binary alphabet (M=2). In the example of FIG 9, the alphabet of symbols used for the codeword x 21 is an alphabet M=4.

In this example, there is a Hamming weight Wj in respect of each symbol $S_j$. The Hamming weight $W_j$ is the number of occurrences of the $S_j$ in the codeword x.

The value w is replaced by $w_j$ which is the number of occurrences of the symbol Sj in the remainder of the codeword x. The initialization at block 132 defines a starting value for each $w_j$ as $W_j$.

The block 134 is specific to a particular symbol $S_j$. The block 134 comprises a search through all j.

The block 134 identifies the symbol $S_j$ at position n in the codeword x and, at block 136, updates the Hamming Weight $w_j$ for symbol $S_j$. In block 136 the value $C_{n,w}$ is replaced by $C_n^j(w_1, w_2, w_3, w_4)$ where j is the index representing symbol $S_j$.

The EC matcher 20 / de-matcher 60 can be directly generalized to any alphabet size M. For a quaternary alphabet (M=4), for instance, the binomial coefficients $C_{n,w}$ of the CC-EC should be replaced by the multinomial coefficients

$$C_{n,w_0,w_1,w_2,w_3} = \frac{n!}{w_0!\,w_1!\,w_2!\,w_3!} \; ; \; w_0 + w_1 + w_2 + w_3 = n$$

and the recursion becomes:

$$C_{n,w_0,w_1,w_2,w_3} = C_{n-1,w_0-1,w_1,w_2,w_3} + C_{n-1,w_0,w_1-1,w_2,w_3} + C_{n-1,w_0,w_1,w_2-1,w_3}$$
$$+ C_{n-1,w_0,w_1,w_2,w_3-1}$$

Also

$$C_n^0(w_0, w_1, w_2, w_3) = 0$$

$$C_n^1(w_0, w_1, w_2, w_3) = C_{n-1,w_0-1,w_1,w_2,w_3}$$

$$C_n^2(w_0, w_1, w_2, w_3) = C_{n-1,w_0-1,w_1,w_2,w_3} + C_{n-1,w_0,w_1-1,w_2,w_3}$$

$$C_n^3(w_0, w_1, w_2, w_3) = C_{n-1,w_0-1,w_1,w_2,w_3} + C_{n-1,w_0,w_1-1,w_2,w_3} + C_{n-1,w_0,w_1,w_2-1,w_3}$$

The multinomial algorithm of FIG 8 will reduce to the binomial algorithm of FIG 3 when j=1, the alphabet is M=j+1. The multinomial algorithm of FIG 9 will reduce to the binomial algorithm of FIG 4A when j=1, the alphabet is M=j+1.

The matcher 60 and de-matcher pair can be used as a distribution matcher 20 and distribution de-matcher pair 60. A distribution matcher 20 produces symbol codewords 21 with a controlled probability distribution. For example, in probabilistic amplitude shaping, symbols of lower amplitude can be produced with a higher probability than symbols of a higher amplitude.

The probability of occurrence of the symbols Sj is controlled by choosing $W_j$, which determines the maximum number of occurrences of symbol type Si, in the codeword 21 produced by the matcher 20. Either fixed or variable composition coefficients can be used in truncated or untruncated form.

Probabilistic amplitude shaping can be achieved by assigning lower symbol count $W_j$ for symbols $S_j$ that have larger amplitude and by assigning higher symbol count $W_j$ for symbols $S_j$ that have lower amplitude.

A larger alphabet M of symbols is used for the codeword x 21. This allows symbols $S_j$ of different amplitude (different level) to be used to create codewords x 21.

The probability of occurrence of the symbols $S_j$ is controlled by choosing $W_j$, which determines the maximum number of occurrences of symbol type $S_j$, in the codeword 21 produced by the matcher 20. Variable composition coefficients can be used in truncated or untruncated form.

Probabilistic amplitude shaping can be achieved by assigning lower symbol count $W_j$ for symbols $S_j$ that have larger amplitude and by assigning higher symbol count $W_j$ for symbols $S_j$ that have lower amplitude.

**Multiple binomial Matchers**

The following examples discuss multi-level distribution matchers 220. A larger alphabet M of symbols is used for the codeword x 21. This allows symbols Sj of different amplitude (different level) to be used to create codewords x 21.

The multi-level distribution matcher 20 can control the probability $p_j$ of occurrence of the symbols $S_j$ in the codeword. The multilevel distribution matcher 20 is configured to generate symbols with independent statistics.

The probabilities of symbol occurrence depend on the choice of the control parameters for enumerative coding such as, for example, values of W and values for the shaping rate (R=Nb/N) which determines the number of information bits Nb per codeword length N. The Hamming Weight of the codeword can be a programmable parameter. For example, the codeword can have a symbol composition that can vary with an index value up to a maximum value, wherein the maximum value is a programmable parameter. The length Nb can be a programmable parameter. The length N can be a programmable parameter.

Probabilistic amplitude shaping can be achieved by assigning lower symbol count $W_j$ for symbols $S_j$ that have larger amplitude and by assigning higher symbol count $W_j$ for symbols $s_j$ that have lower amplitude.

The multi-level distribution matchers 220 in the following example comprise multiple binary distribution matchers 20.

For example, the following examples of multi-level distribution matchers 220 are discussed:.

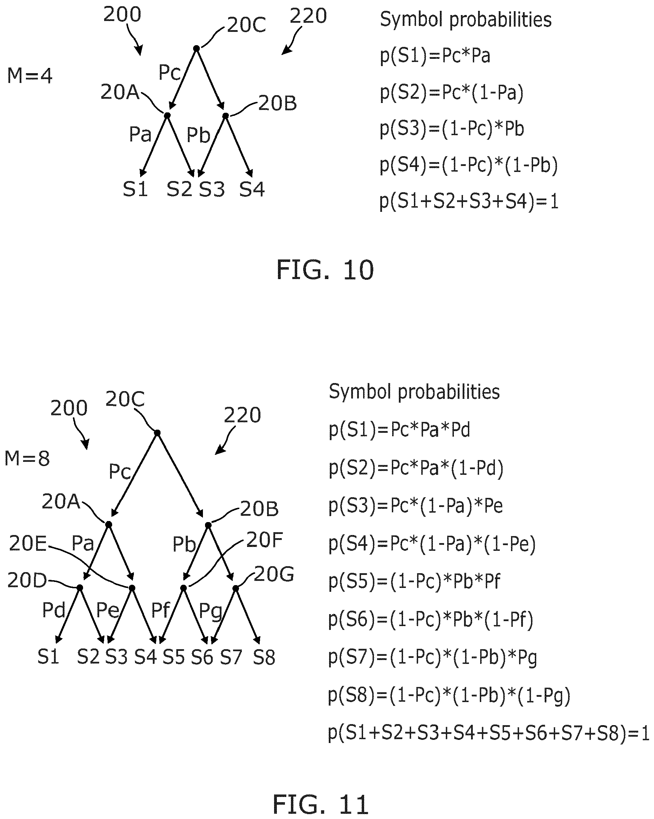

Binary tree of M-1 binary distribution matchers (FIG 10, 11);

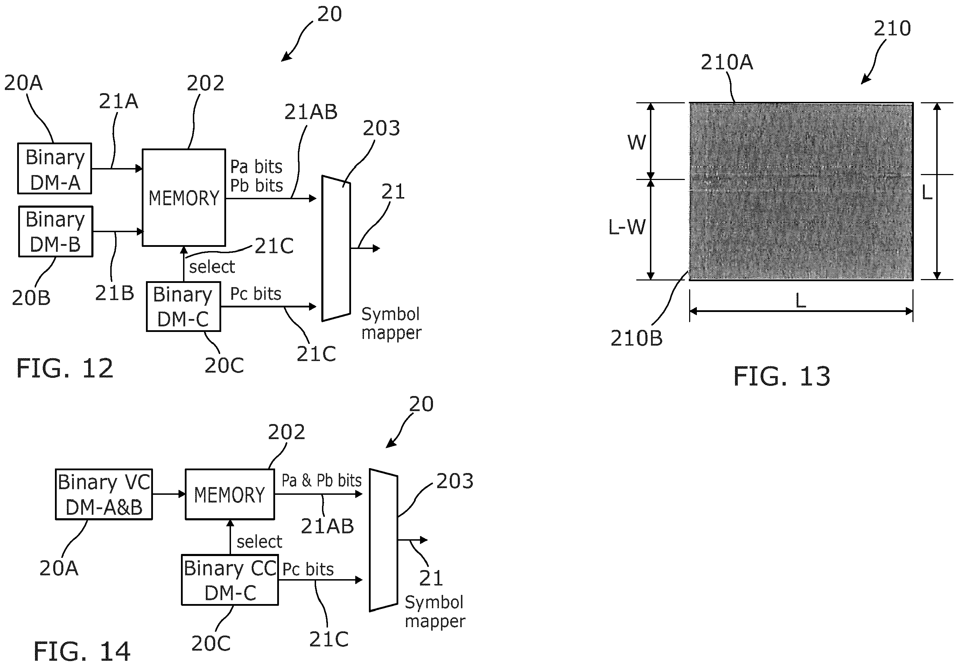

M-1 binary distribution matchers comprising multiple parallel generator binary distribution matchers and one or more selector binary distribution matchers (FIG 12, 14);

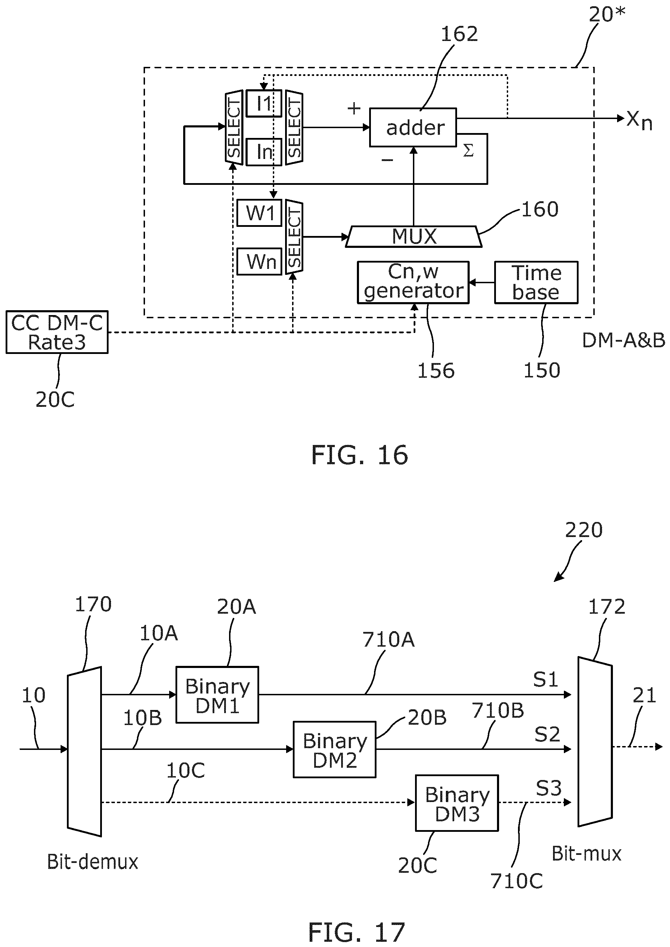

M-1 parallel generator binary distribution matchers (FIG 17); and

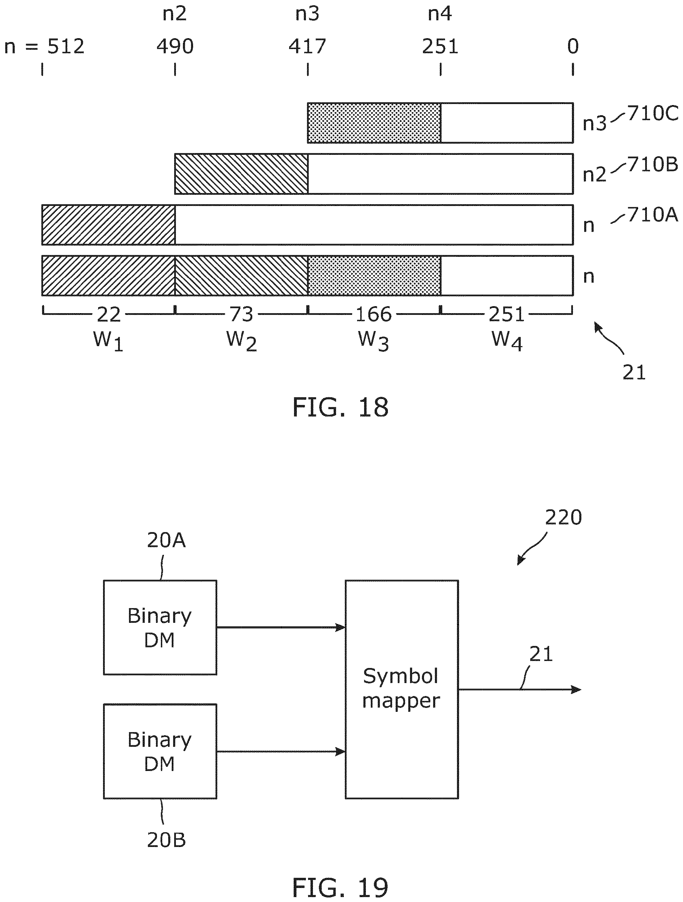

$\log_2 M$ parallel generator binary distribution matchers (FIG 19).

In these examples, for each one of multiple contiguous portions of a data block, multi-level distribution matcher 220 uses a binary matcher to convert each portion of the data block to a binary bit stream to create multiple binary bit streams while controlling a probability of occurrence of logic ones within each of the multiple binary bit streams; and uses the multiple binary bit streams to control a probability of occurrence of multiple multi-level symbols within the codeword. In some but not necessarily all examples, a probability of occurrence of high amplitude symbols is controlled to be less than a probability of occurrence of low amplitude symbols.

As illustrated in the examples of FIGS 10 and 11, a binary tree of binary distribution matchers 20 can be configured as a codeword trellis. Each node in the trellis is represented by binary distribution matcher. The combination of binary distribution matchers arranged as a binary tree forms a multi-level distribution matcher that can create a codeword that uses an alphabet M.

A codeword 21 that uses an alphabet of M symbols and is produced by a multi-level distribution matcher 220 can be represented as a bi-furcating tree where each node except the end nodes are connected downstream to two child nodes and each node except the root node is connected upstream to one parent node. The level q in the binary tree has M=2^q nodes in that level and 2^0 +2^1 + 2^2 +...2^(q-1) =M-1 nodes in the previous upstream levels. Thus M-1 binary distribution matchers 20 arranged as a binary tree can create a codeword that uses an alphabet M.

The equivalent de-matcher 60 can have the same architecture- M-1 binary distribution matchers 20 arranged as a binary tree. Each node except the start nodes are connected upstream to two child nodes and each node except the root node is connected upstream to one parent node. The level q in the binary tree has M=2^q nodes in that level and 2^0 +2^1 + 2^2 +...2^(q-1) =M-1 nodes in the following levels. Thus M-1 binary distribution matchers 20 arranged as a binary tree can process a codeword that uses an alphabet M.

**FIG 10** schematically illustrates a multi-level distribution matcher 220 configured as binary tree 200 of binary distribution matchers 20A, 20B, 20C. In this example, M=4 and there are three binary distribution matchers in two levels.

The binary distribution matcher 20C at the root produce a "1" with probability pc. The binary distribution matcher 20C can be a matcher 20 as previously described where M=2. The probability can, for example, be controlled by selecting W used for constant composition binary enumerative coding, as previously described. The first bit of the symbol produced is therefore "1" with probability pc and the first bit of the symbol produced is therefore "0" with probability (1-pc).

One binary distribution matcher 20A at the next level produces a "1" with probability pa. The binary distribution matcher 20A can be a matcher 20 as previously described where M=2. The probability can, for example, be controlled by selecting W used for constant or variable composition binary enumerative coding in the binary matcher 20A, as previously described. The second bit of the symbol produced is therefore "1" with probability pa and the second bit of the symbol produced is therefore "0" with probability (1-pa). For this distribution matcher 20, the first bit of the symbol produced is "1" with probability pc. The probability of symbol 11 (S1) being output is therefore p1=pc*pa. The probability of symbol 10 (S2) being output is therefore p2=pc*(1-pa). One binary distribution matcher 20B at the next level (same as 20A) produces a "1" with probability pb. The binary distribution matcher 20B can be a matcher 20 as previously described where M=2. The probability can, for example, be controlled by selecting W used for constant or variable composition binary enumerative coding in the distribution matcher 20B, as previously described. The second bit of the symbol produced is therefore "1" with probability pb and the second bit of the symbol produced is therefore "0" with probability (1-pb). For this distribution matcher 20B, the first bit of the symbol produced is "0" with probability (1-pc). The probability of symbol 01 (S3) being output is therefore p3=(1-pc)*pa. The probability of symbol 00 (S4) being output is therefore p4=(1-pc)*(1-pa).

The 4 symbol probabilities p1, p2, p3, p4 are arbitrary and independent. The probability of the symbols Sj is controlled by choosing W for each binary distribution matchers 20A, 20B, 20C.

pa, pb, pc are the bit level probabilities generated by binary distribution matchers 20A, 20B, 20C working at 3 different rates Ra, Rb, Rc (determined by three different Hamming Weights W). The binary distribution matcher 20C working with bit probability pc can use Constant Composition. The binary distribution matchers 20A, 20B working with bit probability pa and pb can be Constant or Variable Composition.

**FIG 11** schematically illustrates a multi-level distribution matcher 220 configured as a binary tree 200 of binary distribution matchers 20. In this example, M=8 and there are 7 binary distribution matchers 20 in three levels.

The binary tree 200 represent a trellis. The route through the trellis determines the output symbol S. The bitwise probability of each bit in the symbol is determined by a different binary distribution matcher 20. Consequently, each route through the trellis occurs with a distinct controllable probability formed by the product of each bit-wise probability for each step in the route.

The 8 symbol probabilities are arbitrary and independent. Pa, Pb, Pc, Pd, Pe, Pf, Pg are the bit level probabilities generated by DMs working at 7 different rates. The binary distribution matcher 20 working with bit probability pa, pb, pc (the internal nodes) use Constant Composition binary enumerative coding as previously described. The binary distribution matchers 20 working with bit probability Pd, Pe, Pf, Pg (the last level of binary distribution matchers 20) uses Constant or Variable Composition binary enumerative coding as previously described.

**FIG 12 & 14** illustrates an example of a multi-level binary distribution matcher 220 to generate sequences with 4 level symbols (M=4). A first set 20A, 20B of the multiple M-1=3 binary matchers 20 is configured to generate symbols 21A, 21B for inclusion in the codeword 21 and a second set 20C of the multiple M-1=3 binary matchers 20 is configured to select the order of the generated symbols 21A, 21B in the codeword 21. The generators can be variable composition or constant composition. The selector(s) are constant composition. The symbol mapper 203 combines an ordered symbol sequence 21AB, selected from the generated symbols 21A, 21B, with symbols 21C from second set 20C of the multiple M-1=3 binary matchers 20 to generate the M=4 level symbols codeword 21 with the desired statistics.

In this example, the binary distribution matcher 20C selects whether the distribution matcher 20A or the distribution matcher 20B provides a bit of the symbol.

In this example, the binary distribution matcher 20C selects whether the distribution matcher 20A or the distribution matcher 20B provides a bit of the symbol for each of L bits. The symbol mapper 203 interleaves a binary symbol form the sequence 21AB, selected from the generated symbols 21A, 21B, with a binary symbol 21C from the output of the distribution matcher 20C to generate the codeword 21 with M=4 level symbols.

In the example of Fig 12, the binary distribution matcher 20A puts forward pa*L candidates for selection. The binary distribution matcher 20B puts forward pb*L candidates for selection. The binary distribution matcher 20C selects the distribution matcher 20A to provide the bit of the symbol with a probability pc and selects the distribution matcher 20B to provide the bit of the symbol with a probability (1-pc). Engineering symbol probabilities (S1, S2, S3, S4) is done by combining the bit probabilities of the binary-tree of binary distribution matchers (pa, pb, pc) according to the equations in FIG 10.

The bit probabilities depend on the choice of the values of W for each binary distribution matcher 20A, 20B, 20C and on the shaping rates of the binary distribution matchers 20A, 20B, 20C. The shaper rate R=Nb/N determines the number of information bits Nb per codeword length N.

The values of W are the Hamming Weights used by the binary distribution matchers 20A, 20B. 20C and can be controlled. The values of the shaper rates used by the binary distribution matchers 20A, 20B. 20C can be controlled.

In the binary tree architecture, the binary distribution matcher 20C which acts as a selector is constant composition.

A codeword 21A of length pa*L is produced by the binary distribution matcher 20A according to the enumerative encoding algorithm using appropriate values for N, Nb and W. The values N, Nb and W control the bit-wise probability pa of producing a "1" bit within the codeword.

A codeword 21B of length pb*L is produced by the binary distribution matcher 20B according to the enumerative encoding algorithm using appropriate values for N, Nb and W. The values N, Nb and W control the bit-wise probability pb of producing a "1" bit within the codeword.

A codeword 21C of length L is produced by the binary distribution matcher 20C according to the enumerative encoding algorithm using appropriate values for N, Nb and W. The values N, Nb and W control the bit-wise probability pc of producing a "1" bit within the codeword.

The sequences of bits at the binary-tree architecture output 21 are generated by selecting and reordering bits from the codewords 21A, 21B generated by the binary distribution matchers 20A, 20B using the bit values of the codeword 21C generated by the binary distribution matchers 20C. The reordered sequence of symbols 21AB is interleaved with the symbols 21C.

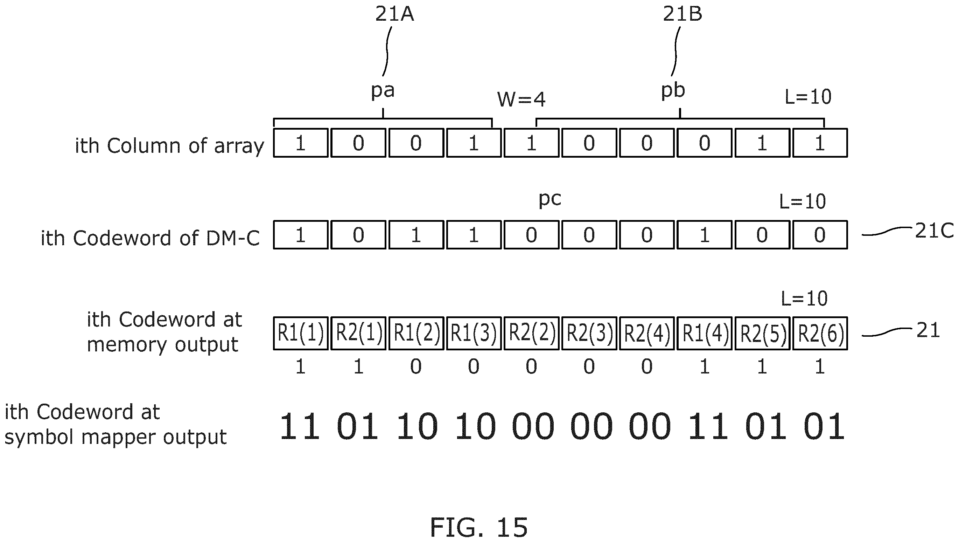

This is illustrated in **FIG 15**. In FIG 15, R1(j) is the $i^{th}$ bit of the binary-tree output codeword 21A which is generated by the binary distribution matcher 20A working at rate Ra with bit probability of ones pa.

R2(k) is the $k^{th}$ bit of the binary-tree output codeword 21B which is generated by the binary distribution matcher 20B working at rate Rb with bit probability of ones pb. R3(i) is the $i^{th}$ bit of the binary-tree output codeword 21C which is generated by the binary distribution matcher 20C working at rate Rc with bit probability of ones pc. RO(i) is the $i^{th}$ bit of the codeword 21AB which is output.

The following pseudo code produces the codeword 21AB from the codewords 21A, 21B, 21C:

```
Let i=j=k=1
Repeat
{If R3(i) ="1", then
     RO(i) =R1(j)
     j++
     i++
Endif
If R3(i) ="0", then
     RO(i) =R2(k)
     k++
     i++
Endif}
```

In the example of FIG 15, the ith codeword 21AB at memory output is 1100000111, where underline is from codeword 21A. Similarly, the codeword 21 at the symbol mapper output is [11 01 10 10 00 00 00 11 01 01], where underline is from the codeword 21AB and the other bits are from the codeword 21C.

Referring back to FIG 12, in one but not necessarily all implementations, a memory 202 is used to store the codewords 21A with size of pa*L symbols produced by the binary distribution matcher 20A and the codewords 21B of size of pb*L symbols is produced by the binary distribution matcher 20B.

The distribution matcher 20A fills the memory 202 with L codewords 21A of length pa*L and L codewords 21B of length pb*L and produces L codewords 21.

L parallel distribution matchers 20A can be used to fill the memory 202 with L codewords 21A of length pa*L. L parallel distribution matchers 30B can be used to fill the memory 202 with L codewords 21B of length pa*L.

The parallel distribution matchers 20A, 20B can share the same coefficient table 156; 156A, 15B.

Alternatively, W=pc*L parallel distribution matchers 20A can be used to fill the memory 202 with W codewords 21A of length L. L-W=(1-pc)*L parallel distribution matchers 20B can be used to fill the memory 202 with L-W codewords 21B of length L. This generates L^2 output bits (L codewords of length L), of which a pool A of L^2*pc=W*L bits have a probability pa, while the remaining pool B of L^2*(1-pc)=(L-W)*L bits have a probability pb. The pool A 210A has W rows each of length L. The pool B 210B has (L-W) rows each of length L. The combination 210 of pool A and pool B, illustrated in FIG 13, comprises W rows each of length L (pool A 210A) and (L-W) rows each of length L (pool B 210B). Each column of the combined pool 210 comprises W bits from pool A and (L-W) bits from pool B. Now we can (via L "C type" matchers 130C) select whether to transmit, for each of the L bits of the output codeword 21, from the pool A or from pool B.

This is illustrated in **FIG 15**. In FIG 15, R1(j) is the ith bit of the ith column of pool 210A. R2(k) is the kth bit of the ith column of the pool 210B. R3(i) is the ith bit of the binary-tree output codeword 21C which is generated by the binary distribution matcher 20C. RO(i) is the ith bit of the codeword 21AB which is output.

As illustrated in FIG 12, the output 21C of binary distribution matcher 20C and L relevant selected bits 21AB can be used together produce output symbols 21, which then have the desired occurrence probabilities.

Each codeword 21 at the symbol mapper 203 output is composed of a sequence of two bits symbols (4 levels case of figure 12). The first (least significant) bit of each 2-bits-symbol is taken from the reordered sequence 21AB, while the second bit of each 2-bits-symbol is taken from the output 21C of the binary distribution matcher 20C. Interleaving is done by the symbol mapper 203. Thus, the codewords 21 are composed by all bits from 21A, 21B and 20C.

In the example illustrated in **FIG 14**, the distribution matcher 20 is similar to the distribution matcher 20 illustrated in FIG 12. However, in this case a single binary distribution matcher 20* is used to operate as binary distribution matcher 20A and binary distribution matcher 20B.

The binary distribution matcher 20* generates W*L bits with bit probability pa and then switches to generate (L-W)*L bits with bit probability pb. As before L^2 bits are stored in a memory 202 as a combined pool 210.

The binary distribution matcher 20C (constant composition) generates L codewords with bit probability pc with Hamming Weight W and length L to reorder the bits in each column of the combined pool 210. The L reordered columns are the L output codewords 21AB form the memory 202. The sequence of symbols 21AB is interleaved with the symbols 21C by symbol mapper 203 to produce codewords 21.

There is also a second embodiment or mode of operation for the circuit of figure 14, which is preferable because it requires a smaller size of memory 202:.

1) The Binary DM 20* generates W bits with probability pa and then switches to generate (L-W) bits at pb.
2) L bits are stored in a memory array.
3) The binary distribution matcher 20C (constant composition) generates codewords 21C with bit probability pc with Hamming Weight W and length L to reorder the elements in the DM 20* codeword.
4) The reordered codeword 21AB from the memory 202 is routed to the symbol mapper 203.

**FIG 16** illustrates an example of a binary distribution matcher 20* that can be used to operate as binary distribution matcher 20A and binary distribution matcher 20B.

The binary distribution matcher 20* generates bits with probability pa or bits with probability pb depending on the control bit from the distribution matcher 20C, working with bit probability pc.

The binary distribution matcher 20* is similar to the matcher 20 illustrated in FIG 5. It differs in that it can operate as a binary distribution matcher 20A at rate Ra (using respective second register 152A for storing the current Hamming Weight w for the rate Ra and third register 154A for storing the current index value for the rate Ra) or as a binary distribution matcher 20B at rate Rb (using respective second register 152B for storing the current Hamming Weight w for the rate Rb and third register 154B for storing the current index value for the rate Rb).

The time base and the first register 150 is shared, the adder logic 162 is shared, the table of coefficients 156 is shared, and the coefficient selection circuitry 160 is shared.

The binary distribution matcher 20A is initialized to work with values for Ia, Wa, Na depending on the rate Ra. The binary distribution matcher 20B is initialized to work with values for Ib, Wb, Nb depending on the rate Rb. For this reason the coefficients $C_{n,w}$ are selected as a function of the algorithm iteration and of the rate. The $C_{n,w}$ generator 156 will produce the required coefficient to complete each iteration as a function of the rate, searching from a unique positions within the reference table for rate Ra and for rate Rb.

The distribution matcher 20C, working with bit probability pc selects whether the binary distribution matcher 20* operates as either:

    i) binary distribution matcher 20A at rate Ra (probability pa) using the second register 152A and third register 154A
    ii) binary distribution matcher 20B at rate Rb (probability pb) using the second register 152B and third register 154B.

A re-sorting memory 202 is not required.

**Fig 17** illustrates an example of a multi-level distribution matcher 220 comprising multiple, parallel binary distribution matchers 20. This architecture is for the case of a quaternary M=4, although it can be easily generalized for higher cardinality by using more parallel binary distribution matchers 20.

Each one of the M-1 parallel binary distribution matchers 20n is responsible for producing statistics for a particular symbol Sn from a different portion of the input bit sequence, data 10 . Each parallel binary distribution matcher 20n can receive the same number of bits Nb from the input data sequence of size M*Nb. The statistics are controlled by controlling the parameters of the binary distribution matcher 20n such as the shaper rate Nb/N, the number of output bits N in the block 710n produced by the binary distribution matcher 20n and the initialization of the Hamming Weight W (for constant composition enumerative coding or variable composition enumerative coding).

A bit de-multiplexer 170 demultiplexes the data 10. It partitions the input information block 10 in three contiguous sub-blocks 10A, 10B, 10C each routed to a different binary distribution matcher 20. The size Nb of each sub-block 10A, 10B, 10C can be the same or chosen according to the shaping rate of the associated binary distribution matcher 20, which depends on the statistics of symbols.

The first binary distribution matcher 20A generates the statistics for symbol S1, the second binary distribution matcher 20B generates the statistics for symbol S2, the third binary distribution matcher 20C generates the statistics for symbol S3.

Then the trellis coefficients of the three binary distribution matchers 20 are:

first binary distribution matcher 20A

$$C_{n,w_1} = \frac{n!}{w_1!} \quad n = w_1 + w_2 + w_3 + w_4$$

second binary distribution matcher 20B

$$C_{n_2,w_2} = \frac{n_2!}{w_2!} \quad n_2 = n - w_1$$

third binary distribution matcher 20C

$$C_{n_3,w_3} = \frac{n_3!}{w_3!} \quad n_3 = n_2 - w_2$$

Where n3 is the size of the output block 710C from the third binary distribution matcher 20C, n2 is the size of the output block 710B from the second binary distribution matcher 20B, n is the size of the output block 710A from the first binary distribution matcher 20A.

The three output blocks 710A, 710B, 710C with the coded bits generated by the binary distribution matchers 20A, 20B, 20C are routed to a bit multiplexer 172.

The bit multiplexer 172 generates symbols S1, S2, S3 and S4 as a function of the sequences 710A, 710B, 710C generated by the three binary distribution matchers 20A, 20B, 20C, using priority encoding. The logical ones in the sequence generated by first binary distribution matcher 20A indicate the positions of symbol S1 in the output codeword 21. The logical ones in the sequence generated by second binary distribution matcher 20B indicate the positions of symbol S2 in the output codeword 21. The logical ones in the sequence generated by third binary distribution matcher 20C indicate the positions of symbol S3 in the output codeword 21. The remaining unallocated positions in the output codeword 21 indicate positions of the symbol S4 in the output codeword.

The bit-mux 172 combines symbols S1, S2, S3, S4 at their respective positions into a single output block of size n, which is the output codeword 21. As described, this is accomplished taking advantage of the size and distributions of logical ones and zeros in each output block 710A, 710B, 710C.

For example, referring to FIG 18, let [S4=251 S3=166 S2=73 S1=22] be the desired composition (Hamming Weight $W_n$) of symbols $S_n$ for a quaternary alphabet in the output codeword 21. Where S1/S2/S3/S4 refers to the exact (constant composition enumerative coding) or to the maximum (variable composition enumerative coding) number symbols of each type in the final codeword 21 at the output of the bit-mux 712.

The first binary distribution matcher 20A gives the statistics for S1 and is assigned w1 = 22 and n = 512 to generate an output block 710A of 512 bits, containing logical ones only in w1 = 22 positions of the output block 710A of length n = 512 bits. The positions of the 22 logical ones in the sequence of length n indicate the positions of the symbols S1 in the codeword 21 of length

The second binary distribution matcher 20B gives the statistics for S2 and is assigned w2 = 73 and n2 = 490 to generate an output block 710B of 490 bits containing logical ones only in w2 = 73 positions of the output block 710B of length n2=490 bits. The positions of the 73 logical ones in the sequence of length n indicate the positions of the symbols S2 in the codeword 21 of length n.

The third binary distribution matcher 20C gives the statistics for S3 and is assigned w3 = 166 and n3 = 417 to generate an output block 710C of 417 bits containing logical ones only in w3=166 positions of the output block 710C of length n3=417 bits. The positions of the 166 logical ones in the sequence of length n indicate the positions of the symbols S3 in the codeword 21 of length n.

The remaining 251 positions in the sequence of length n indicate the positions of the symbols S4 in the codeword 21 of length n

Other symbol orderings are possible, of course.

Fig 19 illustrates an example of a multi-level distribution matcher 220 comprising multiple, parallel binary distribution matchers 20. This architecture is for the case of a quaternary M=4, although it can be easily generalized for higher cardinality by using more parallel binary distribution matchers 20.

Each one of the $\log_2 M$ parallel binary distribution matchers 20n is responsible for producing statistics for a particular bit of a symbol Sn from a different portion of the input bit sequence, data 10 . Each parallel binary distribution matcher 20n can receive the same number of bits Nb from the input data sequence of size M*Nb. The statistics are controlled by controlling the parameters of the binary distribution matcher 20n such as the shaper rate Nb/N, the number of output bits N in the block 710n produced by the binary distribution matcher 20n and the initialization of the Hamming Weight W (for constant composition enumerative coding or variable composition enumerative coding).

If the probability distribution of the sequence S is separable, for instance with M=4,

The probability that the first binary distribution matcher 20A produces a logical 1 for the most significant bits (MSB) is pa.

The probability that the first binary distribution matcher 20A produces a logical 0 for MSB is 1-pa.

The probability that the second binary distribution matcher 20B produces a logical 1 for the least significant bits (LSB) is pb.

The probability that the second binary distribution matcher 20B produces a logical 0 for the LSB is 1-pb.

The probabilities p1, p2, p3, p4 of the symbols S1=[1,1], S2=[1,0], S3=[0,1], S4=[0,0] is

$p_1 = p_a p_b$; $P_2 = p_a(1 - p_b)$; $p_3 = (1 - p_a)p_b$; $p_4 = (1 - p_a)(1 - p_b)]$

we can obtain a multilevel matcher combining $\log_2 M$ binary matchers to generate binary labels with the desired probability distribution. The binary labels of the respective bits of a symbol are combined alternatively by the symbol mapper (MSB from first binary distribution matcher 20A, LSB from second binary distribution matcher 20B), to create a codeword 21 of symbols.

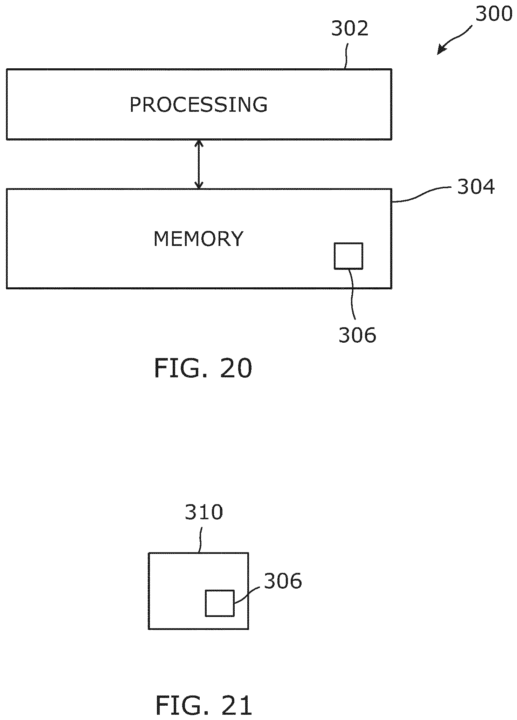

**Fig 20** illustrates an example of a controller 300. Implementation of a controller 300 may be as controller circuitry. The controller 300 may be implemented in hardware alone, have certain aspects in software including firmware alone or can be a combination of hardware and software (including firmware).

As illustrated in Fig 20 the controller 300 may be implemented using instructions 306 that enable hardware functionality. The instructions 306 are machine-readable instructions that are implemented using hardware.

In some but not necessarily all examples, the controller 300 may be implemented using executable instructions of a computer program 306 in a general-purpose or special-purpose processor 302 that may be stored on a computer readable storage medium (disk, memory etc) to be executed by such a processor 302.

The processor 302 is configured to read from and write to a memory 304. The processor 302 may also comprise an output interface via which data and/or commands are output by the processor 302 and an input interface via which data and/or commands are input to the processor 302.

The memory 304 stores a computer program 306 comprising computer program instructions (computer program code) that controls the operation of the apparatus 20, 20*, 60, 220 when loaded into the processor 302. The computer program instructions, of the computer program 306, provide the logic and routines that enables the apparatus to perform the methods illustrated in preceding Figs. The processor 302 by reading the memory 304 is able to load and execute the computer program 306.

The apparatus 20, 20*, 60, 220 therefore comprises:

at least one processor 302; and
at least one memory 304 including computer program code
the at least one memory 304 and the computer program code configured to, with the at least one processor 302, cause the apparatus 20, 20*, 60, 220 at least to perform one or more of:

conversion between data of a fixed length and a modulation codeword of a fixed length;
constrained but variable modulation symbol composition;
enumerative coding (decoding or encoding);
using truncated coefficients for coding;
use of Hamming Weight and a coding index value as stored state variables and coding bit position as a clocked value;
controlling probability of occurrence of multiple modulation symbols, for example using parameters of enumerative decoding (Nb, N, W); and
as a binary matcher to convert each portion of a data block to a binary bit stream.

As illustrated in **Fig 21**, the computer program 306 may arrive at the apparatus 20, 20*, 60, 220 via any suitable delivery mechanism 310. The delivery mechanism 310 may be, for example, a machine readable medium, a computer-readable medium, a non-transitory computer-readable storage medium, a computer program product, a memory device, a record medium such as a Compact Disc Read-Only Memory (CD-ROM) or a Digital Versatile Disc (DVD) or a solid state memory, an article of manufacture that comprises or tangibly embodies the computer program 306. The delivery mechanism may be a signal configured to reliably transfer the computer program 306. The apparatus 20, 20*, 60, 220 may propagate or transmit the computer program 306 as a computer data signal.

The machine-readable instructions that when implemented using hardware (e.g. computer program instructions) for causing an apparatus to perform at least one or more of:

conversion between data of a fixed length and a modulation codeword of a fixed length;
constrained but variable modulation symbol composition;
enumerative coding (decoding or encoding);
using truncated coefficients for coding;
use of Hamming Weight and a coding index value as stored state variables and coding bit position as a clocked value;
controlling probability of occurrence of multiple modulation symbols, for example using parameters of enumerative decoding (Nb, N, W); and
as a binary matcher to convert each portion of a data block to a binary bit stream.

The machine-readable instructions (e.g. computer program instructions) may be comprised in a computer program, a non-transitory computer readable medium, a computer program product, a machine readable medium. In some but not necessarily all examples, the computer program instructions may be distributed over more than one computer program.

Although the memory 304 is illustrated as a single component/circuitry it may be implemented as one or more separate components/circuitry some or all of which may be integrated/removable and/or may provide permanent/semi-permanent/ dynamic/cached storage.

Although the processor 302 is illustrated as a single component/circuitry it may be implemented as one or more separate components/circuitry some or all of which may be integrated/removable. The processor 302 may be a single core or multi-core processor.

References to 'computer-readable storage medium', 'computer program product', 'tangibly embodied computer program' etc. or a 'controller', 'computer', 'processor' etc. should be understood to encompass not only computers having different architectures such as single /multi- processor architectures and sequential (Von Neumann)/parallel architectures but also specialized circuits such as field-programmable gate arrays (FPGA), application specific circuits (ASIC), signal processing devices and other processing circuitry. References to computer program, instructions, code etc. should be understood to encompass software for a programmable processor or firmware such as, for example, the programmable content of a hardware device whether instructions for a processor, or configuration settings for a fixed-function device, gate array or programmable logic device etc.

As used in this application, the term 'circuitry' may refer to one or more or all of the following:

(a) hardware-only circuitry implementations (such as implementations in only analog and/or digital circuitry) and
(b) combinations of hardware circuits and software, such as (as applicable):

(i) a combination of analog and/or digital hardware circuit(s) with software/firmware and
(ii) any portions of hardware processor(s) with software (including digital signal processor(s)), software, and memory(ies) that work together to cause an apparatus, such as a mobile phone or server, to perform various functions and

(c) hardware circuit(s) and or processor(s), such as a microprocessor(s) or a portion of a microprocessor(s), that requires software (e.g. firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor and its (or their) accompanying software and/or firmware. The term circuitry also covers, for example and if applicable to the particular claim element, a baseband integrated circuit for a mobile device or a similar integrated circuit in a server, a cellular network device, or other computing or network device.

In at least some example, the matcher 20 converts data blocks 10 to respective modulation codewords, for controlling transmission, comprising:

converting each data block of fixed first bit length to an index value;
enumeratively decoding the index value to obtain a codeword for controlling transmission.

In at least some examples, the data block has a first fixed bit length and the obtained codeword has a second fixed bit length greater than the first fixed bit length.

In at least some examples, the obtained codeword has a constrained but variable symbol composition that can vary with the index value.

In at least some examples, the means control enumerative decoding to control a probability of occurrence of multiple symbols, for modulating transmission, within the codeword. For example, a probability of occurrence of high amplitude symbols can be controlled to be less than a probability of occurrence of low amplitude symbols

In at least some examples, the de-matcher 60 comprises means for converting codewords to respective data blocks comprising: enumeratively encoding the codeword to obtain an index value; and converting each index value to a data block.

In at least some examples, the data block has a first fixed bit length and the codeword has a second fixed bit length greater than the first fixed bit length.

In at least some examples, the codeword has a constrained but variable symbol composition and the index value varies with a variable symbol composition of the codeword.

The blocks illustrated in at least some of the Figs may represent steps in a method and/or sections of code in the computer program 306. The illustration of a particular order to the blocks does not necessarily imply that there is a required or preferred order for the blocks and the order and arrangement of the block may be varied. Furthermore, it may be possible for some blocks to be omitted.

Components illustrated in the FIGs as being interconnected are operationally coupled and any number or combination of intervening elements can exist (including no intervening elements).

Where a structural feature has been described, it may be replaced by means for performing one or more of the functions of the structural feature whether that function or those functions are explicitly or implicitly described.

As used here 'module' refers to a unit or apparatus that excludes certain parts/components that would be added by an end manufacturer or a user. The apparatus 20, 20*, 60, 220 can be a module.

The above described examples find application as enabling components of: automotive systems; telecommunication systems; electronic systems including consumer electronic products; distributed computing systems; media systems for generating or rendering media content including audio, visual and audio visual content and mixed, mediated, virtual and/or augmented reality; personal systems including personal health systems or personal fitness systems; navigation systems; user interfaces also known as human machine interfaces; networks including cellular, non-cellular, and optical networks; ad-hoc networks; the internet; the internet of things; virtualized networks; and related software and services.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one.." or by using "consisting".

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although embodiments have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain embodiments, those features may also be present in other embodiments whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer and exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

**Claims**

1. An apparatus comprising:

   a first register, for a pointer to a current bit position, updated by a clock cycle;
   a second register for a current Hamming Weight;
   a third register for a current index value; and
   adder logic configured to:

determine an interim value based on a coefficient provided from a memory and the current index value, cause updating of the second and third registers comprising writing an updated index value based on the interim value to the third register.

2. An apparatus as claimed in claim 1, comprising multiple second registers for multiple current Hamming Weights for different symbols; wherein the coefficient is symbol dependent, and wherein the adder logic is configured to cause updating of the second register for a symbol and cause updating of the third register comprising writing an updated index value based on the symbol dependent coefficient to the third register.

3. An apparatus as claimed in claim 1 or 2, wherein the coefficient is provided from the memory in dependence upon the current index value provided by the third register and the current Hamming Weights provided by the second register.

4. An apparatus as claimed in claim 3, comprising:

means for accessing a set of multiple coefficients stored in the memory using a current value of the current bit position from the first register;
means for selecting one coefficient of the accessed set of multiple coefficients using a current value of the current Hamming Weight from the second register, wherein the selected coefficient is used to determine the interim value.

5. An apparatus as claimed in any preceding claim, wherein the coefficient is a truncated coefficient and wherein the adder logic is sized for a mantissa of a truncated coefficient, and is configured to operate on most significant bits of a current index value and a mantissa of the truncated coefficient to produce most significant bits of an interim value, that is added to least significant bits of current index value to obtain the interim value.

6. An apparatus as claimed in any preceding claim comprising means for initialization of the first register to a variable value and means for initialization of the second register to a variable value.

7. An apparatus as claimed in any preceding claim comprising, in parallel, multiple circuit modules each of which comprises a second register for a current Hamming Weight, a third register for a current index value; and adder logic, wherein the parallel circuits share the first register and/or share the memory.

8. An apparatus as claimed in any preceding claim, implemented in hardware comprising application specific circuitry.

9. An apparatus as claimed in any preceding claim, comprising means for configuring the apparatus for use in a transmitter or for use in a receiver.

10. An apparatus as claimed in any preceding claim, comprising means for using the interim value to determine a condition, wherein when the condition is satisfied the adder logic is configured cause updating of the second and third registers comprising writing the updated index value based on the determined condition to the third register and determining a symbol for the codeword at the current bit position.

11. An apparatus as claimed in claim 10, configured to:

determine the condition based on a difference between the coefficient and the current index value provided by the third register,
wherein if the difference

a) has a first sense, then a first symbol is found in the codeword at the current bit position, the second register value is decremented by 1 and the third register value is decremented by the coefficient; and
b) has a second sense, then a second symbol is found in the codeword at the current bit position and there is no change to the second register or the third register.

12. An apparatus as claimed in any preceding claim comprising means for transmitting a modulated signal controlled by the codeword.

13. An apparatus as claimed in any of claims 1 to 9, configured to:

35

i) decrement the second register value by 1 and increment the third register value by the coefficient when the codeword at the current bit position has a first symbol; and
ii) not change the second register value and the third register value when the codeword at the current bit position has a second symbol.

14. An apparatus as claimed in any of claims 1 to 9 or claim 13 comprising means for receiving a modulated signal controlled by the codeword.

15. An optical high speed transmission system comprising, in a transmitter, the apparatus of any of claims 1 to 12 or in a receiver the apparatus of any of claims 1 to 9 and 12 and 13.

FIG. 1

FIG. 2

Flowchart of matcher (enumerative decoder)

FIG. 3

Flowchart for de-matching in reverse bit-order
(from last to first codeword bit)

FIG. 4B

Flowchart of de-matcher (enumerative encoder)

FIG. 4A

FIG. 5

FIG. 6

FIG. 7

FIG. 8

FIG. 9

200    20C    220      Symbol probabilities

M=4                     p(S1)=Pc*Pa

        Pc              p(S2)=Pc*(1-Pa)

20A                     p(S3)=(1-Pc)*Pb
           20B
Pa  Pb                  p(S4)=(1-Pc)*(1-Pb)

S1  S2 S3  S4           p(S1+S2+S3+S4)=1

## FIG. 10

            20C
200                220      Symbol probabilities

M=8                         p(S1)=Pc*Pa*Pd
        Pc
                            p(S2)=Pc*Pa*(1-Pd)
20A
              20B           p(S3)=Pc*(1-Pa)*Pe
20E  Pa    Pb
              20F           p(S4)=Pc*(1-Pa)*(1-Pe)
20D              20G
Pd  Pe  Pf  Pg              p(S5)=(1-Pc)*Pb*Pf

S1  S2 S3 S4 S5 S6 S7  S8   p(S6)=(1-Pc)*Pb*(1-Pf)

                            p(S7)=(1-Pc)*(1-Pb)*Pg

                            p(S8)=(1-Pc)*(1-Pb)*(1-Pg)

                            p(S1+S2+S3+S4+S5+S6+S7+S8)=1

## FIG. 11

FIG. 12

FIG. 13

FIG. 14

EP 3 767 457 A1

EP 3 767 457 A1

21A                              21B

pa              W=4              pb              L=10

ith Column of array | 1 | 0 | 0 | 1 | 1 | 0 | 0 | 0 | 1 | 1 |

pc                              L=10

ith Codeword of DM-C | 1 | 0 | 1 | 1 | 0 | 0 | 0 | 1 | 0 | 0 |  21C

L=10

ith Codeword at
memory output | R1(1) | R2(1) | R1(2) | R1(3) | R2(2) | R2(3) | R2(4) | R1(4) | R2(5) | R2(6) |  21

1     1     0     0     0     0     0     1     1     1

ith Codeword at
symbol mapper output

**11 01 10 10 00 00 00 11 01 01**

FIG. 15

FIG. 16

FIG. 17

FIG. 18

FIG. 19

300

302

PROCESSING

304

MEMORY

306

FIG. 20

310

306

FIG. 21

Europäisches
Patentamt
European
Patent Office
Office européen
des brevets

**EUROPEAN SEARCH REPORT**

Application Number

EP 19 18 6375

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/055569 A1 (TOMIC RATKO V [US]) 16 March 2006 (2006-03-16) * paragraph [0042] - paragraph [0068]; figures 1,7 * | 1-15 | INV. G06F7/74 H03M13/11 |
| A | PIETER M SCHALKWIJK J: "An Algorithm for Source Coding", IEEE TRANSACTIONS ON INFORMATION THEORY, IEEE PRESS, USA, vol. 18, no. 3, 1 May 1972 (1972-05-01), pages 395-400, XP002416891, ISSN: 0018-9448, DOI: 10.1109/TIT.1972.1054832 * Section II * | 1-15 | |
| A | US 2016/352359 A1 (ORDENTLICH ERIK [US] ET AL) 1 December 2016 (2016-12-01) * paragraph [0025] - paragraph [0029] * | 1-15 | |

TECHNICAL FIELDS
SEARCHED      (IPC)

G06F
H03M

The present search report has been drawn up for all claims

| Place of search | Date of completion of the search | Examiner |
|---|---|---|
| Munich | 8 January 2020 | Tenbieg, Christoph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 18 6375

This annex lists the patent family members relating to the patent documents cited in  the above-mentioned European search report.
The members are as contained in the European Patent Office EDP file on
The European Patent Office is in no way liable for these particulars which are merely given for the purpose of information.

08-01-2020

| Patent document cited in search report | Publication date | Patent family member(s) | Publication date |
|---|---|---|---|
| US 2006055569  A1 | 16-03-2006 | US    2006055569  A1<br>US    2007040710  A1 | 16-03-2006<br>22-02-2007 |
| US 2016352359  A1 | 01-12-2016 | US    2016352359  A1<br>WO    2015116184  A1 | 01-12-2016<br>06-08-2015 |

EPO FORM P0459

For more details about this annex : see Official Journal of the European Patent Office, No. 12/82